(19) Europäisches Patentamt
European Patent Office
Office européen des brevets

(11) **EP 2 429 085 B1**

(12) **EUROPEAN PATENT SPECIFICATION**

(45) Date of publication and mention of the grant of the patent:
**28.02.2018 Bulletin 2018/09**

(21) Application number: **09845992.8**

(22) Date of filing: **18.06.2009**

(51) Int Cl.:
*H03M 13/29* (2006.01)  *H03M 13/39* (2006.01)

(86) International application number:
**PCT/CN2009/072339**

(87) International publication number:
**WO 2010/145078 (23.12.2010 Gazette 2010/51)**

(54) **METHOD AND APPARATUS FOR PARALLEL TURBO DECODING IN LONG TERM EVOLUTION SYSTEM (LTE)**

VERFAHREN UND VORRICHTUNG ZUR PARALLELEN TURBODECODIERUNG IN EINEM LTE-SYSTEM (LONG TERM EVOLUTION)

PROCÉDÉ ET APPAREIL POUR DÉCODAGE TURBO EN PARALLÈLE DANS UN SYSTÈME À TECHNOLOGIE D'ÉVOLUTION À LONG TERME (LTE)

(84) Designated Contracting States:
**AT BE BG CH CY CZ DE DK EE ES FI FR GB GR HR HU IE IS IT LI LT LU LV MC MK MT NL NO PL PT RO SE SI SK TR**

(43) Date of publication of application:
**14.03.2012 Bulletin 2012/11**

(73) Proprietor: **ZTE Corporation**
**Shenzhen, Guangdong 518057 (CN)**

(72) Inventor: **ZHAO, Xingshan**
**Shenzhen**
**Guangdong 518057 (CN)**

(74) Representative: **Petraz, Gilberto Luigi et al**
**GLP S.r.l.**
**Viale Europa Unita, 171**
**33100 Udine (IT)**

(56) References cited:
WO-A2-2009/043918     CN-A- 1 728 563
CN-A- 1 913 368       CN-A- 101 026 439
CN-A- 101 409 599     CN-A- 101 411 071
US-A1- 2005 273 687

• MARANDIAN M ET AL: "Performance analysis of turbo decoder for 3GPP standard using the sliding window algorithm", IEEE INTERNATIONAL SYMPOSIUM ON PERSONAL, INDOOR AND MOBILE RADIO COMMUNICATIONS. PIMRC, XX, XX, 30 September 2001 (2001-09-30), pages E-121, XP002403879,

**Description**

Technical Field

The present invention relates to the field of wireless communication, digital signal processing and integrated circuit design, and in particular, to a calculating method and an implementing apparatus for Turbo decoding in a LTE (3GPP long term evolution) system.

Background Art

Turbo codes adopts a parallel concatenated encoder structure, and their decoding adopts iteration decoding mechanism, which is significantly characterized in that the data bit error performance after iteration decoding in an additive white Gaussian noise channel is very close to the Shannon limit.

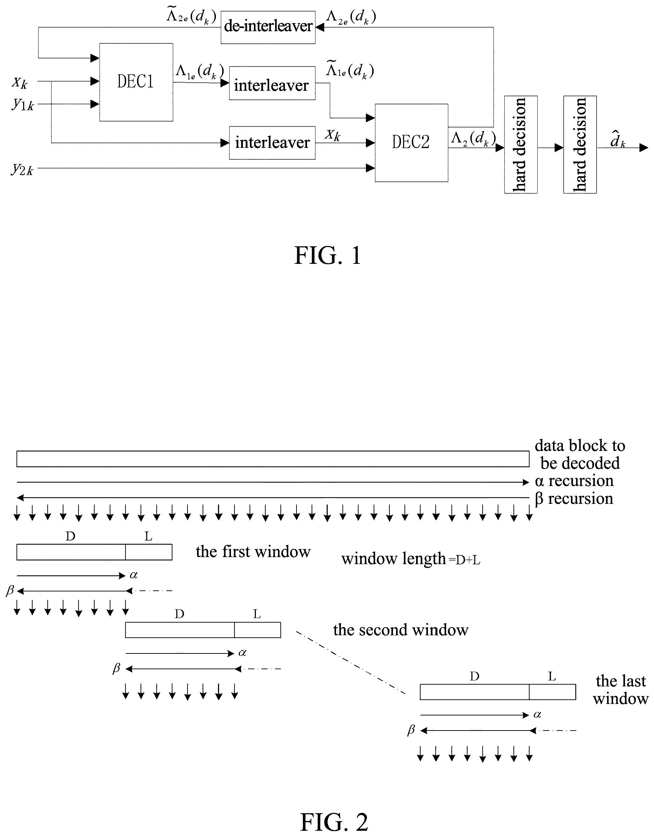

The conventional Turbo decoding adopts BCJR algorithm (or MAP algorithm), and Log-Map algorithm, which is an improved MAP (MaxaProbability) algorithm, is commonly adopted in engineering implementation in order to reduce complexity. As shown in FIG. 1, it is the schematic diagram of Turbo decoding iteration calculation. A Turbo decoder is composed of two soft input soft output (SISO) decoders DEC1 and DEC2 in series, and the interleaver is the same with the interleaver used in the encoder. The decoder DEC1 performs optimal decoding on the component code RSC1 (RSC is Recursive Systematic Convolution codes, and $x_k$ and $y_{1k}$ in FIG. 1 are RSC1), generating likelihood ratio information about each bit in the information sequence u, and the "new information" therein is sent to the DEC2 after being interleaved, the decoder DEC2 uses the information as priori information, and performs optimal decoding on the component code RSC2 $(x_k$ and $y_{2k}$ in FIG. 1 are RSC2), generating likelihood ratio information about each bit in the interleaved information sequence, and then the "extrinsic information" therein is sent to DEC1 after de-interleaving for the next decoding. Thus, after multiple iterations, the extrinsic information of DEC1 and DEC2 tends to be stable, and the asymptotic value of the likelihood ratio is approximate to the maximum likelihood decoding of the whole code, then, by performing a hard decision on this likelihood ratio, the optimal estimation sequence $\hat{u}$ of each bit of the information sequence u, i.e., the final decoding bit, can be obtained.

The Log-Map algorithm can be indicated with the following recursion formula:

Suppose the symbols $\overline{\alpha_k}, \overline{\beta_k}, \overline{\gamma_k}$ are used to represent natural logarithms of $\alpha_k, \beta_k, \gamma_k$, then,

$$\bar{\alpha}_k(S_k) = \ln \alpha_k(S_k)$$

$$\bar{\beta}_k(S_k) = \ln \beta_k(S_k)$$

$$\bar{\gamma}_{k,k+1}(S_k, S_{k+1}) = \ln \gamma_{k,k+1}(S_k, S_{k+1})$$

According to the following logarithm calculation formulas,

$$\ln(e^\alpha e^\beta) = \alpha + \beta$$

$$\ln(e^\alpha + e^\beta) = \max{}^*(\alpha, \beta)$$

$$\max{}^*(\alpha, \beta) = \max(\alpha, \beta) + \ln(1 + e^{-|\alpha-\beta|})$$

wherein, $\alpha_k$ is forward state vector, $\beta_k$ is backward state vector, $\gamma_k$ is branch metric value.
Then, the metric value calculation is converted into:

$$\bar{\alpha}_{k+1}(S_{k+1}) = \max{}^* \{ [\bar{\alpha}_k(S_k^0) + \bar{\gamma}_{k,k+1}(S_k^0, S_{k+1})], [\bar{\alpha}_k(S_k^1) + \bar{\gamma}_{k,k+1}(S_k^1, S_{k+1})] \}$$

$$\bar{\beta}_k(S_k) = \max_{S_{k+1}}^* \{\bar{\beta}_{k+1}(S_{k+1}) + \bar{\gamma}_{k,k+1}(S_k, S_{k+1})\}$$

$$\bar{\gamma}_{k,k+1}(S_k, S_{k+1}) = \ln P(d_k) + \frac{x_k u_k + y_k v_k^i}{\delta^2}$$

Recursive operation is performed on $\overline{\alpha, \beta, \gamma}$ according to the above expressions, and then the corresponding logarithm likelihood ratio can be obtained as follows:

$$L(d_k) = \max_{(s_k, s_{k+1}):d_k=0}^* \{\bar{\alpha}_k(S_k) + \bar{\beta}_{k,k+1}(S_{k+1}) + \bar{\gamma}_{k,k+1}(S_k, S_{k+1})\}$$

$$- \max_{(S_k, S_{k+1}):d_k=1}^* \{\bar{\alpha}_k(S_k) + \bar{\beta}_{k,k+1}(S_{k+1}) + \bar{\gamma}_{k,k+1}(S_k, S_{k+1})\}$$

Wherein, some of the symbols are defined as follows:

$d_k$ represents the bit input by the encoder at the time of k, k=1,2,.....N.
$S_k$ refers to the state of the register at the time of K. The current state is $S_k$, the input bit is $d_k$, and the state of the register is transferred to $S_{k+1}$.

$P(d_k)$ refers to priori probability of $d_k$, $x_k$ is the system soft bit, $y_k$ is the check soft bit, $u_k$ is the system bit, $v_k^i$ is the check bit, and $\delta^2$ is the AWGN channel noise variance.
$L(d_k)$ is priori information, $\overline{\alpha_{k+1}}(S_{k+1})$ is forward state vector, $\overline{\beta_k}(S_k)$ is backward state vector, and $\gamma_{k,k+1}(S_k, S_{k+1})$ is branch metric value.

Due to the presence of processing such as interleaving/de-interleaving and backward state metric calculation, the Turbo decoder based on log-MAP algorithm cannot perform iteration calculation once until receiving a complete encoding packet, and interleaving delay and processing delay increase as the interleaving depth and RSC code condition number increase, thus affecting service data transmission real-time and the maximum service data rate supported by the decoder. As far as LTE is concerned, it is required that a peak data rate above 100Mb/s is supported, which means that the requirement on the decoding rate of channel encoding is higher, and if the LTE continues to use Turbo codes and their decoding algorithm in 3GPP Rel 6, the above requirement on data rate cannot be satisfied. In order to meet this requirement, the Turbo codes in LTE must adopt a parallel decoding algorithm, and the interleaving method for the interleaver of the encoder for the Turbo codes in LTE is specially designed to support parallel decoding.

The document WO 2009/043918 discloses a system for execution of a decoding method, the system being capable of executing at least two data decoding methods which are different in underlying coding principle, whereby at least one of said data decoding methods requires data shuffling operations on said data. A system according to embodiments of the present invention comprises: at least one application specific processor having an instruction set comprising arithmetic operators excluding multiplication, division and power, the processor being selected for execution of approximations of each of said at least two data decoding methods, at least a first memory unit, e.g, background memory, for storing data, a transfer means for transferring data from the first memory unit towards said at least one programmable processor, said transfer means including a data shuffler, and a controller far controlling the data shuffler independent from the processor.

Summary of the Invention

The technical problem to be solved in the present invention is to provide a method and an apparatus for parallel Turbo decoding in a long term evolution system (LTE) to reduce decoding time delay and increase decoding peak data rate.

The features of the method and system according to the present invention are defined in the independent claims.

A decoding apparatus for parallel Turbo decoding in LTE, comprising: an input storage module, a processing module, a control module and an output module, wherein:

the input storage module is used to implement the following operations under control of the control module: dividing an input frame which is to be decoded into blocks, storing each block respectively as system soft bits; storing input check soft bits; receiving and storing priori information output by the processing unit; and in a process of component decoding, outputting the priori information, system soft bits and check soft bits required by the calculation of the processing unit;

the processing module is used to simultaneously perform component decoding once on several blocks of a frame to be decoded, and in the process of said component decoding, divide each block into several sliding windows according to a sliding window algorithm, and calculate the following parameters according to the system soft bits, the check soft bits and priori information: branch metric value $\gamma$, forward state vector $\alpha$, backward state vector $\beta$, log-likelihood ratio (LLR), and priori information, outputting the priori information to the input storage module to store, completing a decoding process after performing component decoding several times, and transmitting the log-likelihood ratio (LLR) to the output module;

the control module is used to control and coordinate operation of each module, generate control signals of a component decoding process and an iteration process of the processing module, generate input storage module control signals, generate output module control signals, and enable the input storage module and the processing module to proceed with iteration decoding or stop the iteration decoding process according to feedback signals of the output module;

the output module is used to perform a hard decision on the log-likelihood ratio (LLR), judge whether a result of the hard decision meets an iteration ending condition, output the feedback signals to the control module, and output a decoding iteration result as a decoding result when the calculation result meets the ending condition.

Furthermore, the input storage module includes an input memory controller unit, a priori information memory unit, a system soft bit memory unit and a check soft bit memory unit, wherein:

the input memory controller unit is used to generate read-write control signals of each memory, divide a data frame which is to be decoded into blocks according to the number of blocks determined by the control module and then store the blocks into the system soft bit memory unit;

the check soft bit memory unit is used to store the input check soft bits, and includes a first check soft bit memory, a second check soft bit memory and a first multiplexer, wherein the first check soft bit memory outputs a first check soft bit to an input end of the first multiplexer, the second check soft bit memory outputs a second check soft bit to another input end of the first multiplexer, and a control end of the first multiplexer is connected to the control module;

the first multiplexer controls, according to the control signals of the control module, to select the first check soft bit and the second check soft bit as input data respectively in a first component decoding operation and a second component decoding operation;

the system soft bit memory unit is used to respectively store each block of the input divided frame which is to be decoded; the system soft bit memory unit includes a system soft bit memory, a first interleaver and a second multiplexer, wherein the system soft bit memory has two output ends, one output end outputs data directly to an input end of the second multiplexer, and the data output by another output end are input to another input end of the second multiplexer after being interleaved by the first interleaver, and a control end of the second multiplexer is connected to the control module; the second multiplexer is used to output the system soft bits to the processing module in the first component decoding according to the control signals of the control module, and to output the interleaved system soft bits to the processing module in the second component decoding;

the priori information memory unit is used to respectively store results of component decoding of several times, and includes a first priori information memory, a second priori information memory, a first interleaver and a third multiplexer, wherein first priori information output by the first priori information memory is input to an input end of the third multiplexer after being interleaved by the interleaver; the second priori information memory outputs second priori information to another input end of the third multiplexer; a control end of the third multiplexer is connected to the control module; the third multiplexer is used to selectively output the second priori information and the interleaved first priori information to the processing module according to the control signals of the control module.

Furthermore, the system soft bit memory, the first check soft bit memory, and the second check soft bit memory are respectively composed of a plurality of independent small memories that can be read in parallel and written serially, and writing addresses of the small memories are in succession; the first priori information memory and the second priori information memory are respectively composed of a plurality of independent small memories that can be read and written in parallel, and the writing addresses of the small memories are in succession.

Furthermore, the system soft bit memory, the first check soft bit memory, the second check soft bit memory, the first priori information memory and the second priori information memory all support ping-pong operation, each memory is composed of eight small memories, and the size of each small memory is 1536 bytes.

Furthermore, the processing module includes a parallel processing MAP unit, a fourth multiplexer and a second interleaver, wherein the parallel processing MAP unit receives data output by the input storage module, performs component decoding processing and iteration processing several times, completes a decoding process and outputs a decoding result to an input end of the fourth multiplexer, a control end of the fourth multiplexer is connected to the control module, the fourth multiplexer controls, according to the control signals of the control module, to output the first priori information to the first priori information memory in the first component decoding, and output the second priori information to the second interleaver in the second component decoding, the second interleaver outputs one channel of the interleaved second priori information to the second priori information memory and outputs another channel of the second priori information to the output module.

Furthermore, each parallel processing MAP units includes several independent MAP calculating units used to implement parallel component decoding, each MAP calculating unit is composed of a first $\gamma$ calculating unit, a $\beta$ calculating unit, a $\beta$ memory, a second $\gamma$ calculating unit, an $\alpha$ calculating unit, and an LLR calculating unit, wherein:

the first $\gamma$ calculating unit performs branch metric value calculation for calculating $\beta$, and inputs a branch metric value for backward use that is obtained after calculation to the $\beta$ calculating unit; the second $\gamma$ calculating unit performs branch metric value calculation for calculating $\alpha$, and inputs a branch metric value for forward use that is obtained after calculation to the $\alpha$ calculating unit; the $\beta$ calculating unit is used to calculate a backward state vector $\beta$; the $\beta$ memory is used to store the calculated $\beta$; the $\alpha$ calculating unit is used to calculate a forward state vector $\alpha$; the LLR calculating unit is used to calculate log-likelihood ratio and priori information.

Furthermore, the LLR calculating unit includes: a group of sixteen three-input adders, and a first group of eight max* calculating units, a second group of four max* calculating units, a third group of two max* calculating units, and a subtracter; wherein, two adjacent three-input adders perform addition operation as a sub-group, outputting eight addition values in total to the eight max* calculating units in the first group of max* calculating units respectively; in the first group of max* calculating units, two adjacent max* calculating units perform max* calculation as a sub-group, outputting four results in total to the four max* calculating units in the second group of max* calculating units respectively; in the second group of max* calculating units, two adjacent max* calculating units perform max* calculation as a sub-group, outputting two results to the subtracter, getting the difference by the subtracter to obtain the log-likelihood ratio (LLR), and a new priori information is obtained according to the log-likelihood ratio, and system information and priori information input at this time.

Furthermore, the output module includes a hard decision unit, an iteration ending judging unit and an output memory controller unit, wherein, the hard decision unit receives the priori information output by the processing module, sends the priori information to the iteration ending judging unit and the output memory controller unit respectively, the iteration ending judging unit judges whether a result of the hard decision meets the ending condition, and outputs to the control module a feedback signal indicating that the condition is met or the condition is not met; when the ending condition is met, the control module sends an output signal to the output memory controller unit, and the output memory controller unit outputs the decoding result.

Furthermore, it is believed that the iteration condition is met if the iteration ending judging unit judges that the decoding result meets any one of the following conditions: reaching a set number of iterations; judging that a Cyclic Redundancy Check (CRC) calculation result of block data after decoding is correct.

A method for parallel Turbo decoding in a LTE system comprises the following steps of:

storing input check soft bits and a frame to be decoded, and when storing said frame to be decoded, dividing the frame to be decoded into blocks and storing each block respectively as system soft bits; simultaneously performing component decoding once for several blocks of a frame to be decoded, and in the process of said component decoding, dividing each block into several sliding windows according to a sliding window algorithm, and calculating the following parameters according to the system soft bits, the check soft bits and priori information: branch metric value $\gamma$, forward state vector $\alpha$, backward state vector $\beta$, log-likelihood ratio (LLR), and priori information, and storing the priori information for using in a next component decoding; completing a decoding process after performing component decoding several times; performing a hard decision on the LLR, judging whether a result of the hard decision meets an iteration ending condition, if yes, outputting a decoding result, otherwise, proceeding with a next decoding iteration process.

Furthermore, a decoding process includes performing component decoding two times, and in a decoding process, the first component decoding is implemented according to the system soft bits, second priori information obtained in a last component decoding and a first check soft bit; the second component decoding is implemented according to the system soft bits, first priori information obtained in a last component decoding and a second check soft bit; the priori information in the first component decoding in an initial first decoding process is 0.

Furthermore, it is believed that the iteration ending condition is met and the iteration will be ended as long as the decoding result meets any one of the following conditions: reaching the set number of iterations; judging that a Cyclic Redundancy Check (CRC) calculation result of block data after decoding is correct.

Furthermore, the number N of the blocks is determined according to a length K of the frame to be decoded: when K≤512, N=1; when 512<K≤1024, N=2; when 1024<K≤2048, N=4; when 2048<K≤6144, N=8.

Furthermore, in the process of performing calculation on a certain block according to a sliding window algorithm, the block is divided into several sliding windows, wherein:

when calculating a backward state vector $\beta$ of a first sliding window: a value of $\beta$ after L recursions is calculated by taking 0 as an initial value, and then this value of $\beta$ is used as an initial value to perform D recursion calculations, obtaining D values of $\beta$ in turn, which are used as the values of $\beta$ of the first sliding window; when calculating the backward state vector $\beta$ of a last sliding window, if the block where the sliding window is located is the last block, the value of $\beta$ of the last sliding window is obtained by performing D recursions, calculation taking 0 as an initial value; if the block where the sliding window is located is not the last block, a value of $\beta$ after L recursions is calculated by taking 0 as an initial value firstly, and then this value of $\beta$ is used as an initial value to perform D recursion calculations to obtain the value of $\beta$ of the last sliding window; when calculating a forward state vector $\alpha$ of the first sliding window, if the block where the sliding window is located is the first block, then the value of $\alpha$ of this first sliding window is obtained by performing D recursion calculations, taking 0 as an initial value; if the block where the sliding window is located is not the first block, a value of $\alpha$ after L recursions is calculated by taking 0 as an initial value firstly, and then the value of $\alpha$ is used as an initial value to perform D recursion calculations to obtain the value of $\alpha$ of this first sliding window; when calculating a forward state vector $\alpha$ of the last sliding window, the value of $\alpha$ after L recursions is calculated by taking 0 as an initial value, and then this value of $\alpha$ is used as an initial value to perform D recursion calculations, obtaining D values of $\alpha$ in turn, which are used as the values of $\alpha$ of the first sliding window; wherein, $1 \leq L \leq D$.

Furthermore, L=32.

Furthermore, the log-likelihood ratio (LLR) is calculated at the mean time of calculating the forward state vector $\alpha$.

The method and hardware apparatus for implementing Turbo decoding through adaptive segmenting parallel sliding window log-MAP algorithm provided by the present invention can significantly increase decoding rate, reduce decoding delay, and meet the requirements on throughput rate and delay of Turbo decoding in a LTE system with rather small consumption of hardware resources. Specifically, the present invention has the following advantages:

1. greatly reducing the time for processing a single code block, i.e., greatly improving the real-time processing ability of the decoder and reducing decoding delay;
2. decreasing the total memory consumption, and preventing it from continuously expanding with the increase of the length of the data block of the code to be decoded ;
3. facilitating the implementation of high-speedTurbo decoder with hardware (for example, FPGA, ASIC);
4. realizing a Turbo-decoder with a high throughput rate, and meeting the requirements on the performance of the LTE system;
5. synthetically applying techniques such as hardware multiplexing, parallel and pipeline processing, which can bring about beneficial effects of reducing consumption of hardware resources, shortening processing delay and the like respectively.

Brief Description of Drawings

FIG. 1 is a schematic diagram of Turbo decoding iteration calculation;
FIG. 2 illustrates a calculating process of an intra-block sliding window method;
FIG. 3 illustrates the hardware apparatus of the Turbo decoder;

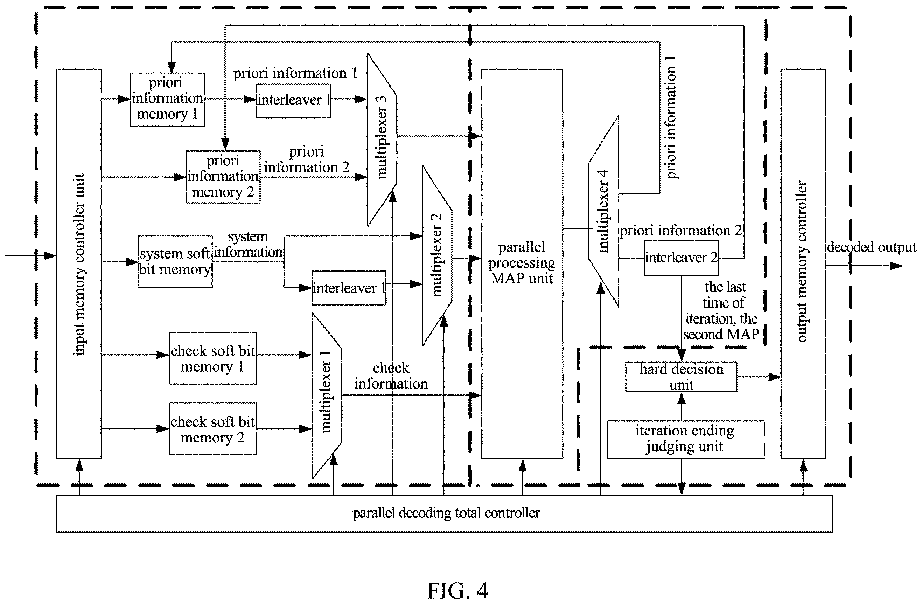

FIG. 4 illustrates the structure of the hardware apparatus of the Turbo decoder;
FIG. 5 illustrates the structure of a parallel processing MAP unit;
FIG. 6 illustrates the structure of the MAP calculating unit;
FIG. 7 illustrates the state transfer of the Turbo decoder;
FIG. 8 illustrates the structure of the hardware of the LLR calculating unit;
FIG. 9 illustrates intra-frame sliding windows calculation;
FIG. 10 illustrates intra-frame sliding window $\alpha$ calculation.

Preferred Embodiments of the Invention

Sliding window algorithm is a continuous decoding algorithm with a fixed decoding delay proposed by S.Benedetto, et al., while sliding window log-MAP algorithm divides a decoding data frame into several sub-frames with a length of each being D, wherein decoding is performed using the sub-frame as a unit, and the decoding algorithm still adopts the log-MAP algorithm, with the difference being that L decoding data are processed further at the tail of each sub-frame to initialize the backward state metric. However, calculation and simulation show that the Turbo decoder directly adopting sliding window log-MAP algorithm is still too far from reaching the decoding rate of 100Mbps regulated by LTE.

Therefore, the present invention provides a method for implementing Turbo decoding through adaptive segmenting parallel sliding window log-MAP algorithm.

The concept of the present invention is: firstly the frame data to be decoded is divided into N (N may be selected among 1, 2, 4, 8) blocks in order, the sliding window algorithm is applied between the N blocks and inside each block respectively; the sliding window method between the N blocks is called as intra-frame sliding window and sliding window method inside each block is called as intra-block sliding window for the sake of briefness. Since intra-block sliding window is implemented in the N blocks of the frame to be decoded simultaneously in parallel, and each frame to be decoded also implements intra-frame sliding window in parallel, the decoding delay can be greatly reduced, and the throughput rate can be increased. Wherein, the intra-block sliding window algorithm is similar to the common sliding window algorithm, i.e., the length of the sliding window is set as w=D+L, the N blocks implement intra-block sliding window algorithm simultaneously in parallel, and in order to realize intra-frame sliding window, each block does not only implement intra-block sliding window calculation for the backward state vector, but also implement intra-block sliding window calculation for the forward state vector during intra-block sliding window, as shown in FIG. 2. Wherein, the initial value of the last window in calculation of backward state vector and the initial value of the first window in calculation of forward state vector are obtained through intra-frame sliding window calculation.

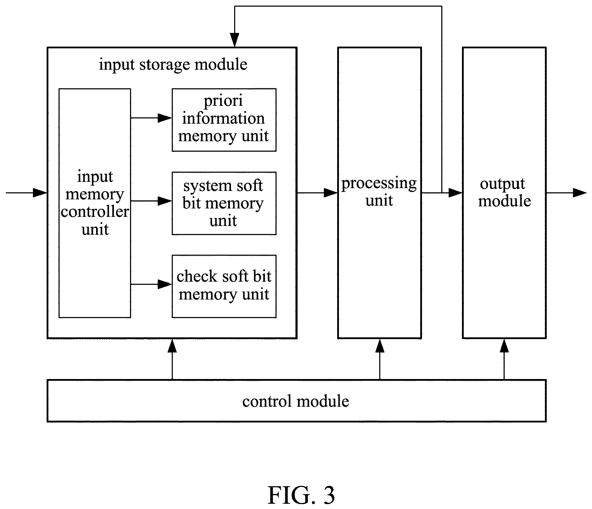

The decoding apparatus for implementing the present invention is as shown in FIG. 3, comprising: an input storage module, a processing module, a control module and an output module, wherein:

the input storage module is used to implement the following operations under control of the control module: dividing an input frame to be decoded into blocks, storing each block respectively as system soft bits; storing input check soft bits; receiving and storing priori information output by the processing unit, and outputting the priori information to the processing unit in the next component decoding; and in a process of component decoding, outputting the priori information, system soft bits and check soft bits required in calculation of the processing unit;

the processing module is used to simultaneously perform component decoding once for several blocks of a frame to be decoded, and in the process of said component decoding, divide each block into several sliding windows according to a sliding window algorithm, and calculate the following parameters according to the system soft bits, the check soft bits and priori information: branch metric value $\gamma$, forward state vector $\alpha$, backward state vector $\beta$, log-likelihood ratio (LLR), and priori information, outputting the priori information to the input storage module to store, completing a decoding process after performing component decoding several times, and transmitting the log-likelihood ratio (LLR) to the output module; for example, an iteration process includes performing component decoding two or more times, and the processing module can perform in time-division the component decoding at least two times. Wherein the first component decoding of an iteration process is implemented according to the system soft bits, the second priori information (i.e., the result of the last component decoding in the last iteration process) and the first check soft bit that are input by the input storage module; the second component decoding of an iteration process is implemented according to the system soft bits, the first priori information (i.e., the result of the first component decoding, i.e., the result of the last component decoding) and the second check soft bit that are input by the input storage module;

the control module is used to control and coordinate operation of each module, generate control signals of a component decoding process and an iteration process of the processing module, generate input storage module control signals, generate output module control signals, and enable the input storage module and the processing module to proceed with or stop the iteration decoding process according to feedback signals of the output module;

the output module is used to perform a hard decision on the log-likelihood ratio (LLR), judge whether a result of the hard decision meets an iteration ending condition, output feedback signals to the control module, and output a decoding iteration calculation result as a decoding result when the calculation result meets the ending condition.

The Turbo decoding apparatus based on adaptive segmenting parallel sliding window Log-MAP algorithm provided by the present invention will be described in detail below.

• Input storage module

The input storage module includes an input memory controller unit, a priori information memory unit, a system soft bit memory unit and a check soft bit memory unit, wherein:

The priori information memory unit is used to respectively store results of component decoding of several times, as shown in FIG. 3, it further includes a priori information memory 1, a priori information memory 2, an interleaver 1 and a multiplexer 3, wherein the first priori information output by the priori information memory 1 is input to an input end of the multiplexer 3 after being interleaved by the interleaver; the priori information memory 2 outputs the second priori information to another input end of the multiplexer 3; a control end of the multiplexer 3 is connected to the control module. The priori information memory 1 is used to store the component decoding result of the first component decoding DEC1--- the first priori information, and to output the interleaved first priori information in the second component decoding DEC2; the priori information memory 2 is used to store the component decoding result of the second component decoding DEC2---the second priori information, and to output the second priori information (i.e., the result of the last component decoding) in the first component decoding DEC1; the multiplexer 3 is used to selectively output the second priori information (in the first component decoding DEC1) and the interleaved first priori information (in the second component decoding DEC2) to the processing module according to the control signals of the control module.

The system soft bit memory unit is used to store each block of the input divided frame to be decoded, as shown in FIG. 3, it further includes a system soft bit memory, an interleaver 1 and a multiplexer 2, wherein the system soft bit memory has two output ends, one output end outputs data directly to an input end of the multiplexer 2, and the data output by another output end are input to another input end of the multiplexer 2 after being interleaved by the first interleaver, and a control end of the multiplexer 2 is connected to the control module. The system soft bit memory is used to store and each block after the input code block division, and these blocks are also called as system soft bits; the multiplexer 2 is used to output the system soft bits to the processing module in the first component decoding DEC1 according to the control signals of the control module, and to output the interleaved system soft bits to the processing module in the second component decoding DEC2. The interleaver in the system soft bit memory unit multiplexes the interleaver in the priori information storage unit. Of course, it can also be realized with another interleaver 3 in other examples.

The check soft bit memory unit is used to store the input check soft bits, as shown in FIG. 3, it further includes a check soft bit memory 1, a check soft bit memory 2 and a multiplexer 1, wherein the check soft bit memory 1 outputs a first check soft bit to an input end of the multiplexer 1, the check soft bit memory 2 outputs a second check soft bit to another input end of the multiplexer 1, and a control end of the multiplexer 1 is connected to the control module. The check soft bit memory 1 is used to store the first check soft bit input from the input memory controller unit; the check soft bit memory 2 is used to store the second check soft bit input from the input memory controller unit. The multiplexer 1 controls, according to the control signals of the control module, to select the first check soft bit and the second check soft bit as input data respectively in the first component decoding DEC1 and a second component decoding DEC2.

The input memory controller unit is used to generate read-write control signals of each memory according to the control signals of the control module, divide a data frame (code block) to be decoded into blocks according to the number of blocks determined by the control module and then store the blocks in the system soft bit memory unit.

The methods for designing the above system soft bit memory, the check soft bit memory 1, and the check soft bit memory 2 are the same. In order to match the calculation requirement on the adaptive segmenting parallel sliding window log-MAP algorithm of the present invention, each of these three input memories is designed to be composed of eight independent small memories that can be read in parallel and written serially respectively, and the write addresses of every eight memories are in succession and increase in turn, the addresses of the eight small memories during reading are independent from each other. Every eight small memories constitute one big memory, i.e., the system soft bit memory or the check soft bit memory 1, or the check soft bit memory 2. In order to increase the throughput rate of the decoder, the memory can also be designed to be a ping-pong operated memory, i.e., the capacity of each small memory is designed to have the size required to support ping-pong operation, the maximum code block length in LTE is 6144, so after evenly dividing into eight blocks, the size of each block is 768, each small memory stores one code block with the size of 768, and in order to support ping-pong operation, each small memory is designed to be 768*2, i.e., 1536 bytes. Here, the width of the memory is determined by the bit width of the input system soft bits or the check soft bits data or the priori information data. When the input data are written into the system soft bit memory, the control module determines, according to the length of the code block, to divide the input into N equal parts, wherein N may be 1, 2, 4, or 8, depending on different code block lengths. The input memory controller unit writes the input data into the N small memories of the system soft bit memory respectively, and each memory stores equally divided data block with the same size.

The priori information memory 1 and the priori information memory 2 are designed in the similar way with the above three memories, i.e., both of the memories are composed of eight small memories, and in order to support ping-pong operation, each small memory has a size of 768*2, i.e., 1536 bytes, and the width of the memory is equal to the bit width of the priori information data. However, the difference is that the priori information memory 1 and the priori information memory 2 support parallel reading/writing of eight channels of data, the data bus and the address bus of every eight small memories constituting the priori information memory are independent, and the read/write enable signals are also independent.

The read/write control rule of the system soft bit memory is: during writing, the eight small memories constituting the system soft bit memory share address and data buses, each small memory writes data in turn, and the enable signals are generated in turn, i.e., after the input data block is divided into N equal parts, the first small memory is firstly enabled, the first small block of data is written into the first small memory, and upon completion of writing, the second small memory is firstly enabled, the second small block of data is written into the second small memory, and so forth, until the $N^{th}$ block of data is completely written. Generation of address signal is divided into the generation of base address (for differentiating ping-memory and pong-memory) and the generation of offset address (for positioning ping- or pong-memory interior data), the write address is the base address added with the offset address: the writing data offset addresses of N small memories that are enabled in turn increase progressively, the address 0 starts with the 0 address of the first small memory, and ends with the last writing data address of the $N^{th}$ small memory. Generation of the base address is determined according to ping-pong operation: ping-pong operation enable signal is input by the control module, the input memory controller unit generates the base address for reading and writing memory according to the ping-pong operation enable signal, the base address is 0 during ping-operation, and the base address is 768 during pong-operation. When reading the data, generation of the control signals needs to be determined by the executing process state of the current decoding. When the processing module implements calculation of the first component decoding DEC1 (i.e., the so-called MAP1 calculation), the read address is the direct address (i.e., interleaving is not needed); when the processing module implements calculation of the second component decoding DEC2 (i.e., the so-called MAP2 calculation), the read address is the address after interleaving. The N activated small memories are read in parallel, each small memory reads the enable signal in the same way, the address bus and data bus are independent, and when the direct address is generated, the base address controls signal is determined based on ping-pong operation control signal, the base address during ping-operation is 0, and during pong-operation it is 768, the offset addresses are the same for each sub-memory, and increase progressively from 0 to K/N-1 (K is the length of the data block to be decoded, and N is the number of the equally divided blocks), the read address is the base address added with the offset address. The direct address is sent to the interleaver to generate an address after interleaving.

The writing operation of the check soft bit memory 1 and the check soft bit memory 2 is the same with that of the system soft bit memory, except in that reading is implemented according to the direct address. When implementing the first component decoding DEC1 calculation, the check soft bit memory 1 is enabled to perform parallel reading of data, and when implementing the second component decoding DEC2 calculation, the check soft bit memory 2 is enabled to perform parallel reading of data.

The input memory controller unit is also responsible for generating read/write control signals of the priori information memories 1 and 2. The write data of the priori information memory 1 is the result output in the first component decoding DEC1, the data are written according to the direct address, and the decoding output priori information generated by N activated MAP calculating sub-units is written into the small memories of the corresponding priori information memory 1 respectively. When reading the priori information memory 1, the address is the interleaving address, i.e., the data of the priori information memory 1 are interleaved and read for performing MAP2 calculation in the second component decoding DEC2. Ping-pong operation is the same with that of the system soft bit memory. The write data of the priori information memory 2 is the result output in the second component decoding DEC2, and when writing data, the address is the interleaving address, i.e., for writing in interleaving, and when reading data, the data are read according to the direct address, and is sent to the first component decoding DEC1 for MAP1 calculation. Ping-pong operation is the same with that of the system soft bit memory.

• Control module

The control module is the parallel decoding general controller in FIG. 3, it is used to generate control signals for decoding of the processing module, which are mainly used to control the time sequencing (for example, forward, backward state vector calculation enable signal, LLR calculation enable signal, etc.) of the execution of the processing module; to generate the control signals (for example, ping-pong operation control) of the input memory controller unit and the control signals of the output memory controller unit and send them to the input storage module and the output module respectively; and to generate control signals of various multiplexers; also to generate decoder iteration enable signal according to the feedback signal of the iteration ending judging unit in the output module, wherein the decoder iteration enable signal is the control signal for controlling whether the whole decoding operation is continued or not, and is a general enable signal for the control module to generate other control signals described above. When a feedback signal indicating that the decoding result fed back by the iteration ending judging unit meets the ending condition is received, the control module controls the output module to output the decoding result, and sends a signal of stopping processing to the input storage module and the processing module, and the Turbo decoding iteration calculation is ended, i.e., MAP decoding operation is ended; when a feedback signal indicating that the decoding result fed back by the iteration ending judging unit does not meet the ending condition is received, the control module controls the processing module to feed back the processing result to the input storage module, and the decoding iteration calculation is continued.

Design of the parallel decoder controller is associated with the decoding process of the decoder, and the controller does not only control the single process of MAP operation, but also controls the processes of multiple-iteration MAP operation.

The parallel decoder controller is also used to generate selection control signals for adaptive segmenting of the code block to be decoded, for example, determining the value of N according to the length of the code block, and generating parallel processing MAP sub-unit activating signal, and the like.

• Processing module

The processing module includes a parallel processing MAP unit, a multiplexer 4 and an interleaver 2, wherein the parallel processing MAP unit receives data (including priori information, system soft bits and check soft bits) output by the input storage module, performs in time-division component decoding processing and iteration processing two times, completes a decoding process and outputs a decoding result (including the first priori information and the second priori information) to an input end of the multiplexer 4. The control end of the multiplexer 4 is connected to the control module. The multiplexer 4 controls, according to the control signals of the control module, to select to directly output the first priori information and output in interleaving the second priori information respectively in the first component decoding DEC 1 operation and the second component decoding DEC2 operation, i.e., the multiplexer 4 outputs the first priori information to the priori information memory 1 in the first component decoding DEC1; the multiplexer 4 outputs the second priori information to the interleaver 2 in the second component decoding DEC2, the interleaver 2 outputs one channel of the interleaved second priori information to the priori information memory 2 and outputs another channel of the interleaved second priori information to the hard decision unit in the output module.

The parallel processing MAP unit is used to implement the functions of the first component decoding DEC1 and the second component decoding DEC2 as shown in FIG. 1, so as to realize the "adaptive segmenting parallel sliding window log-MAP" algorithm of the present invention, wherein, the two component decoding processes, DEC1 and DEC2, time-division multiplex the same set of parallel processing MAP units. When performing DEC1 calculation, the data input to the parallel processing MAP unit are system soft bits, the second priori information and the first check soft bit, and the calculation result is stored into the priori information memory 1 according to the direct address. When performing DEC2 calculation, the data input to the parallel processing MAP unit are interleaved-read system soft bits, and interleaved-read first priori information and the second check soft bit, and the calculation result is written into the priori information memory 2 according to the address for interleaving. After MAP calculations of two times (i.e., DEC1 and DEC2 calculations), a process of Turbo decoding iteration calculation is completed.

The structure and the calculating process of the parallel processing MAP unit will be described in detail below:

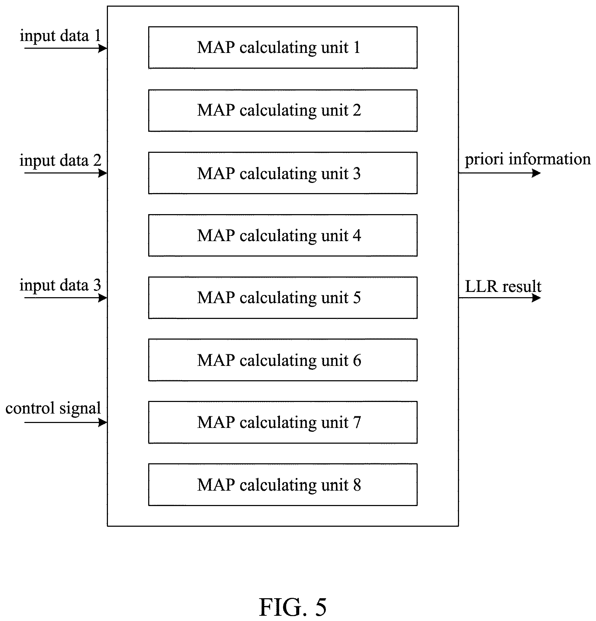

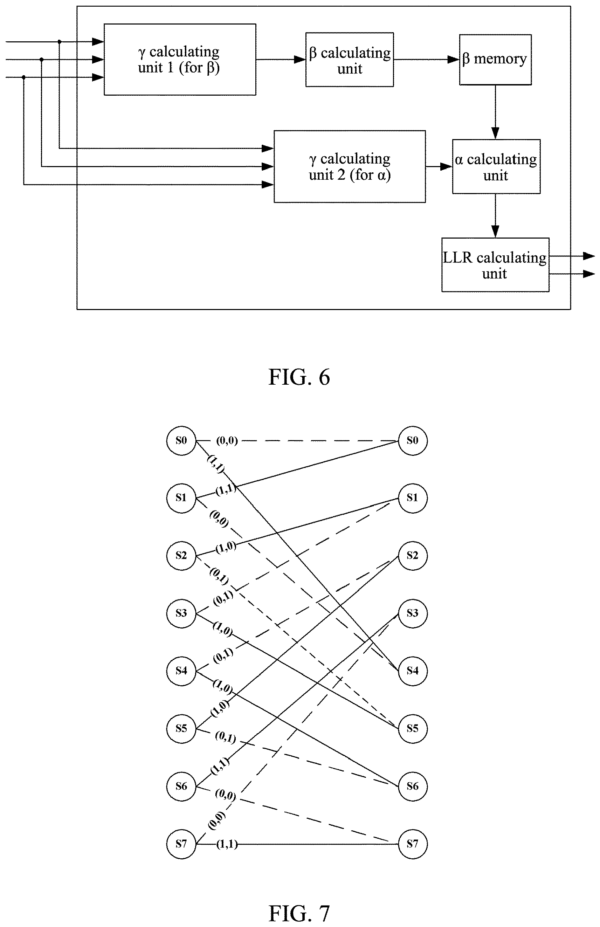

A parallel processing MAP unit includes several independent MAP calculating units for implementing component decoding, and multiple MAP calculating units can support parallel decoding. For example, if eight MAP units are included (as shown in FIG. 5), they can support parallel decoding where the maximum number of N is 8, and when N is not 8, then only corresponding number of MAP calculating units can be activated. The activated several parallel processing sub-units read the several small memories on the corresponding priori information memories, the system soft bit memory and the check soft bit memory in parallel. The read data are sent to the N MAP processing sub-units in parallel. As shown in FIG. 6, each MAP calculating unit consists of a $\gamma$ calculating unit 1, a $\beta$ calculating unit, a $\beta$ memory, a $\gamma$ calculating unit 2, an $\alpha$ calculating unit, and an LLR calculating unit. $\alpha$ and $\beta$ are forward state vector and backward state vector respectively. Wherein, the $\gamma$ calculating unit 1 calculates branch metric value for calculating $\beta$, and inputs the branch metric value for backward-use that is obtained after the calculation to the $\beta$ calculating unit; the $\gamma$ calculating unit 2 calculates branch metric value calculation for calculating $\alpha$, and inputs the branch metric value for forward-use that is obtained after the calculation to the $\alpha$ calculating unit; the $\beta$ calculating unit is used to calculate a backward state vector $\beta$; the $\beta$ memory is used to store the calculated $\beta$, the depth of the memory is equal to D, one of the length parameters of the sliding window, and the bit width of the memory is equal to the bit width of the calculating result of $\beta$, the $\beta$ data memory is designed to adopt a dual-port RAM, each $\beta$ data memory is composed of eight small memories so as to support parallel calculation of eight state vectors; the $\alpha$ calculating unit is used to calculate a forward state vector $\alpha$; the LLR calculating unit is used to calculate log-likelihood ratio and priori information (including the first priori information and second priori information).

When sliding window algorithm is not used, then the size of the memory for storing $\beta$ calculating result is the same with the size of the input code block to be decoded, and the size increases with the increase of the size of the code block to be decoded. Implementation of sliding window algorithm can control the size of the β memory to be within a desired order of magnitude, and if the length of the required memory only needs to be equal to the length of the window, D, then it will not vary as the size of the code block varies.

In order to save equipments, time-division multiplexing is used to realize equipment sharing. With regards to a MAP calculating unit, it is needed to perform calculation of branch metric value γ two times, one is implemented for calculating β while another is implemented for calculating α, therefore, the two calculations are separated in time, as shown in FIG. 6, it can be seen in the longitudinal direction that the γ calculation implemented for β calculation is implemented separately, while the γ calculation implemented for β calculation is implemented at the same time as the β calculation, then the calculated β is stored, meanwhile, α is calculated, and after the first α is obtained through calculation, α and β are input together to the LLR calculating unit for use in LLR and priori information calculation. In other examples, γ calculation may also be firstly implemented separately for α calculation, and then γ calculation and α calculation for β calculation are implemented simultaneously.

Turbo decoding corresponds to three shift registers, i.e., there are only eight states, correspondingly there are eight states respectively before decoding and after decoding, and state transfer is related with the input data (may be 0, or 1), different input data will cause different transfer state after decoding, i.e., as the transfer relationship shown in FIG. 7, each state corresponds to two kinds of input, then there are sixteen transfer relationships (transfer branches) among eight states at two adjacent moments, but there are only four branch metric values, therefore, these four branch metric values can be calculated in parallel during one clock cycle and are output to the subsequent α and β calculating units respectively.

As shown in FIG. 7, calculation of α may adopt eight-channel parallel calculation, and each channel corresponds to one state metric, then eight state metric values of α can be calculated simultaneously within one clock cycle. Similarly, the calculation of β is the same.

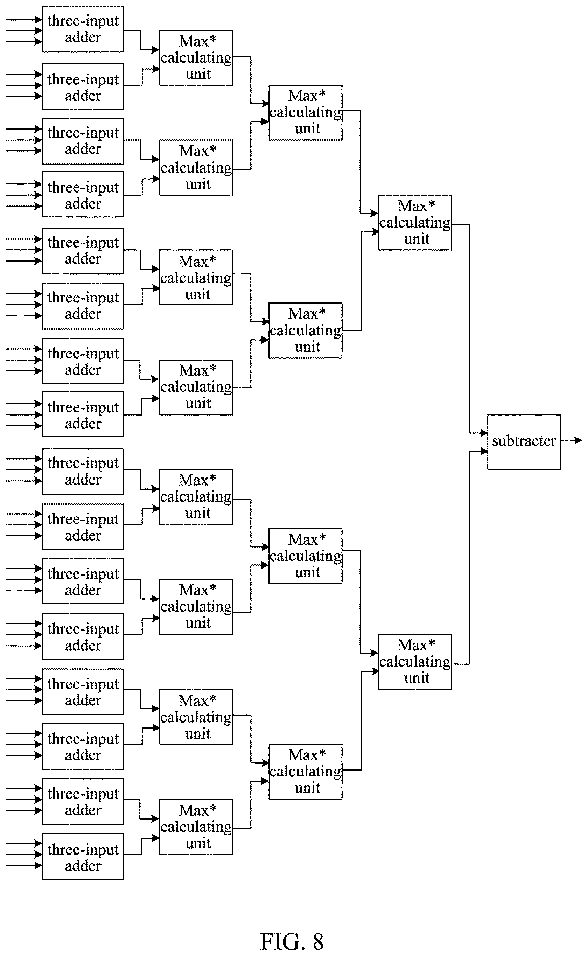

The hardware circuit structure of the LLR calculating unit is as shown in FIG. 8, including:

a group of sixteen three-input adders, and a first group of eight max* calculating units, a second group of four max* calculating units, a third group of two max* calculating units, and a subtracter; wherein, two adjacent three-input adders perform addition operation as a sub-group, outputting eight sum values in total to the eight max* calculating units in the first group of max* calculating units respectively; in the first group of max* calculating units, two adjacent max* calculating units work as a sub-group to perform max* calculation, outputting four results in total to the four max* calculating units in the second group of max* calculating units respectively; in the second group of max* calculating units, two adjacent max* calculating units work as a sub-group to perform max* calculation, outputting two results to the subtracter, getting the difference by the subtracter to obtain the log-likelihood ratio (LLR), and new priori information is obtained by subtracting the system information and priori information input at this time from the log-likelihood ratio.

According to the calculating formula of Log-MAP algorithm, LLR calculation is implemented using MAX or MAX* approximation algorithm.

$$\ln(e^{\alpha} + e^{\beta}) = \max{}^{*}(\alpha, \beta)$$

$$\max{}^{*}(\alpha, \beta) = \max(\alpha, \beta) + \ln(1 + e^{-|\alpha - \beta|})$$

LLR calculation is obtained using the following formula:

$$L(d_k) = \max_{(s_k, s_{k+1}):d_k=0}{}^{*}\{\bar{\alpha}_k(S_k) + \bar{\beta}_{k,k+1}(S_{k+1}) + \bar{\gamma}_{k,k+1}(S_k, S_{k+1})\}$$

$$- \max_{(S_k, S_{k+1}):d_k=1}{}^{*}\{\bar{\alpha}_k(S_k) + \bar{\beta}_{k,k+1}(S_{k+1}) + \bar{\gamma}_{k,k+1}(S_k, S_{k+1})\}$$

LLR calculation can be started after the first α value of the current sliding window is obtained, i.e., it is started one clock cycle later than the α calculation. It can be seen from the above formula that LLR calculation process is as follows:

(1)   calculating   the   sums   of   each   eight   $\alpha$,   $\beta$   and   $\gamma$   in   the   first   group

$$\max_{(s_k,s_{k+1}):d_k=0}^{*}\{\tilde{\alpha}_k(S_k)+\bar{\beta}_{k,k+1}(S_{k+1})+\tilde{\gamma}_{k,k+1}(S_k,S_{k+1})\}$$

and the second group

$$\max_{(S_k,S_{k+1}):d_k=1}^{*}\{\tilde{\alpha}_k(S_k)+\bar{\beta}_{k,k+1}(S_{k+1})+\tilde{\gamma}_{k,k+1}(S_k,S_{k+1})\},$$

which is implemented using a parallel calculating circuit, i.e., eight in each group, sixteen in total, three-input adders, meanwhile, calculating two groups of sum values, with each group having eight sum values.

(2) performing max* operation on every two adjacent values of the eight sums in each group, which is also implemented using a parallel circuit, i.e., each group needs four sets of max* calculating units, i.e., eight sets of max* calculating units are needed in total. Four results in each group are obtained after this step of calculation.

(3) performing max* operation again on pair-wise combination of the four results in each group that are obtained in the second step, then obtaining two results for each group. Parallel calculation is adopted, and this step needs two sets of max* calculating units for each group, i.e., four sets of max* calculating units are needed in total.

(4) continuing to perform max* operation on the two results in each group that are obtained in the third step, and obtaining one value for each group. Parallel calculation is adopted, and each group needs one set of max* calculating units, i.e., two sets of max* calculating units are needed in total.

(5) calculating the difference between the values of the two groups of data that are obtained in the fourth step, i.e, obtaining the final result $L(d_k)$.

Wherein, steps 1 through to 5 are implemented using a pipeline structure, and each step is implemented within a clock cycle as a segment of the pipeline structure. This structure can ensure single-clock cycle continuous output of LLR.

• Output module

the output module includes a hard decision unit, an iteration ending judging unit and an output memory controller unit, wherein, the hard decision unit receives the second priori information output by the processing module, sends the second priori information to the iteration ending judging unit and the output memory controller unit respectively, the iteration ending judging unit judges whether a result of the hard decision meets the ending condition, and outputs to the control module a feedback signal indicating that the condition is met or the condition is not met; when the ending condition is met, the control module sends an output signal to the output memory controller unit, and the output memory controller unit outputs the decoding result.

The hard decision unit performs a hard decision on the LLR result output in the second component decoding DEC2, and if the calculation result is greater than 0, then the result is decided to be 1, otherwise, it is decided to be 0.

The iteration ending judging unit is used to judge in real time the decoding result of each iteration, and it is believed that the iteration condition is met and iteration will be ended if one of the following conditions is met: reaching a set number of iterations; judging that a Cyclic Redundancy Check (CRC) calculation result of block data after decoding is correct. According to the characteristics of the LTE block, since each block after dividing contains CRC check soft bits, whether to end the iteration can be determined by calculating the CRC of the decoded data, if the CRC calculating result is correct, it suggests that the decoding result is correct, and the iteration can be ended.

In order to coordinate with the parallel MAP calculating unit, the iteration ending judging unit may also be designed to adopt parallel calculation, for example, adopting parallel CRC calculation to realize parallel iteration ending judgment.

The above Turbo decoder uses the interleaver in three applications, the first application is interleaved-reading the system soft bits in the second component decoding DEC2 calculation, the second application is interleaved-reading the first priori information in the second component decoding DEC2 calculation, and the third application is interleaved-outputting the second priori information to be written into the priori information memory 2 in the second component decoding DEC2 calculation, and meanwhile sending the second priori information to the hard decision module for hard decision processing. In implementation of the hardware, the interleavers in the first and second applications can be multiplexed, since the addresses for data interleaving from the system soft bit memory and the priori information memory 1 in DEC2 calculation are exactly the same.

The interleaver in the present invention is also designed to coordinate with the parallel processing MAP unit, and adopts parallel calculating method, eight-channel parallel calculation is supported at most in hardware, N channels of parallel calculating units are activated according to the value N calculated by the decoding total controller, meanwhile, the interleaved data required by the parallel processing MAP unit are calculated.

The hardware apparatus of the Turbo decoder provided by the present invention is as described above, and the Turbo decoding process based on "adaptive segmenting parallel sliding window log-MAP algorithm" and the corresponding hardware apparatus proposed in the present invention will be described below:

storing the input check soft bits and a frame to be decoded, and when storing said frame to be decoded, dividing the frame to be decoded into blocks and storing each block respectively as system soft bits; simultaneously performing component decoding once for several blocks of a frame to be decoded, and in the process of said component decoding, dividing each block into several sliding windows according to a sliding window algorithm, and calculating the following parameters according to the system soft bits, the check soft bits and priori information: branch metric value $\gamma$, forward state vector $\alpha$, backward state vector $\beta$, log-likelihood ratio (LLR), and priori information, and storing the priori information for use in a next component decoding; completing a decoding process after perform component decoding several times; performing a hard decision on the LLR, judging whether a result of the hard decision meets an iteration ending condition, if yes, outputting a decoding result, otherwise, proceeding with a next process of decoding iteration.

Furthermore, the above decoding method may comprise the following steps:

1. judging the current working state of the decoder, if the input memory (including the system soft bit memory, and the check soft bit memories 1 and 2) can receive new code block input, then inputting new code blocks, and after the new code blocks are completely written into the input memory, setting corresponding code block valid signals, and waiting for decoding. Since ping-pong operation is supported, data of two different code blocks at most can be stored simultaneously.
2. judging the current working state of the parallel MAP processing unit, and if it is idle and there are valid data blocks to be decoded, starting the decoding process;
3. the decoding total controller generating decoding control signals according to the information such as the corresponding block length of the data block to be decoded, the set number of iterations, and so on, and activating the corresponding MAP calculating units and the corresponding data memories;
4. directly reading the priori information memory 2, system soft bit memory, and check soft bit memory 1 in the first component decoding DEC1 operation of the first iteration process, wherein, the second priori information in the first component decoding DEC1 operation of the first iteration process is 0, performing MAP calculation according to the working process of the MAP calculating unit, and storing the obtained result into the priori information memory 1;
5. interleaved-reading the system soft bit memory, priori information memory 1, and directly reading the priori information memory 2 in the second component decoding DEC2 operation of the first iteration process, performing MAP calculation according to the working process of the MAP calculating unit, and interleaved-writing the obtained result into the priori information memory 2 and sending the result to the hard decision module;
6. the hard decision module performing a hard decision and writing the result into the iteration ending judging unit;
7. the iteration ending judging unit judging whether the ending condition is met according to the result of the hard decision, and if yes, executing step 8, otherwise, proceeding with the second decoding, and repeating steps 4 and 5; It is believed that the iteration condition is met and iteration will be ended if one of the following conditions is met: reaching a set number of iterations; judging that a Cyclic Redundancy Check (CRC) calculation result of block data after decoding is correct.
8. after Turbo decoding of the current code block is over, setting the parallel MAP calculating unit to be idle, judging whether there are new valid code blocks to be decoded in the input memory, if yes, starting a new decoding process of the code block, otherwise, waiting.

In specific implementation, the length of the code block (frame to be decoded) in LTE ranges from 40 to 6144, with a large difference in the block lengths, so the difference in decoding delays is also very large, and the requirement on parallel decoding of the code block with a larger block length is higher compared with the code block with a less block length. Therefore, the design of the present invention takes into full consideration adopting different parallel processing strategies for different block lengths, i.e., adaptively selecting the value of N based on the block length. For example, when the length K<=512, N=1; when 512<K<=1024, N=2; when 1024<K<=2048, N=4; and when 2048<K<=6144, N=8, wherein K represents the block length.

The process of implementing Turbo decoding through adaptive segmenting parallel sliding window log-MAP algorithm in the method of the present invention will be described in detail below:

It is supposed that t indicates the count value of the window, k indicates the count value of the data in the window, k ranges from 1~D+L, wherein $1 \le t \le \lceil (K-L)/ND \rceil$, K represents the length of the data frame to be decoded, N represents the number of blocks for parallel processing, D represents a basic window length in sliding window method, L is the overlap window required by initial value calculation, $1 \le L \le D$, preferably, L=32, D+L represents a complete sliding window length.

**1) Calculation of the backward state vector of the first window length**

Suppose t=1, the initial value of $\beta$ is firstly calculated, if after the data frame is divided into N equal parts, the length of each data block is less than a set window length D+L, then the data block includes only one sliding window, and the initial value is 0, the values of $\beta$ for the whole data block are reversely iteratively calculated in turn, otherwise, it is to start to calculate $\beta_k$ when the window length of the decoder is equal to D + L, at which moment, $\beta_{k+1}(S_{k+1})\big|_{k \in D \pounds L}$ is totally unknown, and this condition is equivalent to the situation that the decoder may be in any state at the moment of k+1, therefore, $\beta_{k+1}(S_{k+1})\big|_{k \in D \pounds L} = 0$ is used as the recursion initial amount for calculating $\beta_k$. Afterwards, $\beta_k$ recursion calculations are performed L times, and since the degree of confidence of these L $\beta_k$s may be not high enough, they cannot be used to calculate $\Lambda(d_k)$ (priori information). After performing recursion calculations L times, the degree of confidence of $\beta_{D+1}(S_{D+1})$ has progressively reached to a relatively high level, and thus can be used to calculate $\beta_D(S_D)$ at the moment of D, therefore, all $\beta_k$s during the time range from k=D to k=1 can be obtained through recursion calculation.

The process for calculating $\beta_k$ with k being in the range from $k = D \pounds L$ to k=D is precisely a backward setup process, which is an application of intra-block sliding window method. Only the values of $\beta$ of the part of D length are stored in the calculating process, i.e., all values of $\beta_k$ with k being in the time range from k=D to k=1. These values are stored into the $\beta$ data memory. N data blocks are calculated in parallel and the same calculating process is executed.

**2) Calculation of the forward state vector and LLR of the first window length**

The value of $\alpha$ of the first window (t=1) is calculated, if the window is the first window of the first data block, then the initial value is set to be 0, and the values of $\alpha_k$ of the lengths from k=1 to k=D are calculated through recursion calculation, otherwise (the first window of the Nth block, N>1), the initial values for parallel calculating $\alpha_k$ of the first windows of other data blocks cannot be 0, i.e., it needs to firstly calculate $\alpha_0(S_0)$ for calculating the moment of 0, this initial value can be obtained by calculating the L length data of the previous data block, and $\alpha_{K/N-L}(S_{K/N-L})=0$ is used as the initial recursion amount for calculating $\alpha_k$. Afterwards, $\alpha_k$ recursion calculations are implemented L times, and after performing recursion calculations L times, the degree of confidence of $\alpha_{K/N}(S_{K/N})$ of the last data of the previous data block has progressively reached to a relatively high level, and thus can be used to calculate $\alpha_0(S_0)$ of the next data block at the moment of 0, which is an application of intra-block sliding window method. The N data blocks are calculated in parallel, executing the same calculating process, except the process of initial value calculation.
The LLR is also calculated at the mean time of calculating the forward state vector.

**3) Calculation of the backward state vector of the middle window**

Calculation of the backward state vector $\beta$ of the middle window is the same as that of the first widow, $\beta_k$ recursion calculations are firstly implemented L times, i.e., $\beta_k$ calculation with k being in the range from k=D+L to k=D, to obtain the $\beta_{D+1}(S_{D+1})$ value at the moment of D+1, which is used as the initial value of D length $\beta_k$ recursion calculation. Then recursion calculation of all $\beta_k$s with k being in the time range from k=D to k=1 is implemented, and the value of $\beta_k$ of D length is stored. The N data blocks are calculated in parallel, executing the same calculating process.

**4) Calculation of the forward state vector and LLR of the middle window**

The forward state vector of the middle window is calculated according to the intra-block sliding window method, the value of $\alpha$ of the last data of the previous window is used as the initial value for calculating $\alpha_k$ of the current window, i.e., the value of $\alpha_D(S_D)$ of the t-1th window is used as the initial value for calculating $\alpha_0(S_0)$ of the tth window. Recursion calculations are implemented D times in turn, i.e., the calculation of $\alpha_k$ with k being in the range from k=1 to k=D. The N data blocks are calculated in parallel, executing the same calculating process.
Calculation of LLR is implemented while calculating $\alpha_k$, the N data blocks are calculated in parallel, executing the same calculating process.

**5) Calculation of backward state vector of the last window**

The backward state vector of the last window is calculated, if the block is the last data block (it is the first block when N=1, the second block when N=2, the fourth block when N=4, and the eighth block when N=8), then the initial value is 0 when calculating the backward state vector $\beta_k$ of the last window of the last data block. The method for calculating the initial value of the last window of other data blocks that are calculated in parallel is that: the initial values for calculation cannot be 0, i.e., it needs to firstly calculate $\beta_D(S_D)$ for calculating the moment of D, this initial value can be obtained by calculating the L length data of the next data block (N data blocks are numbered sequentially form the first block to the $N^{th}$ block), and $\beta_L(S_L)=0$ is used as the initial recursion amount for calculating $\beta_k$ (K is from L to 0). Afterwards, $\beta_k$ recursion calculations are implemented L times, and after performing recursion calculations L times, the degree of confidence of $\beta_0(S_0)$ of the first data of the next data block has progressively reached to a relatively high level, and thus can be used to calculate $\beta_D(S_D)$ of the previous data block at the moment of D, the initial value for the $\beta_k$ calculation of the last window of the current data block can be obtained through intra-frame sliding window method, then D times of recursion calculations are implemented, D backward state vectors are obtained in turn and stored in the corresponding memories.

The N data blocks are calculated in parallel, executing the same calculating process, except the process of initial value calculation.

6) Calculation of the forward state vector and LLR of the last window

The calculation of the forward state vector of the last window is very simple, and the calculating process is the same with the process for calculating the forward state vector of the middle window, the forward state vector of the last window of the N data blocks is calculated in parallel, executing the same calculating process. Calculation of the LLR is implemented simultaneously.

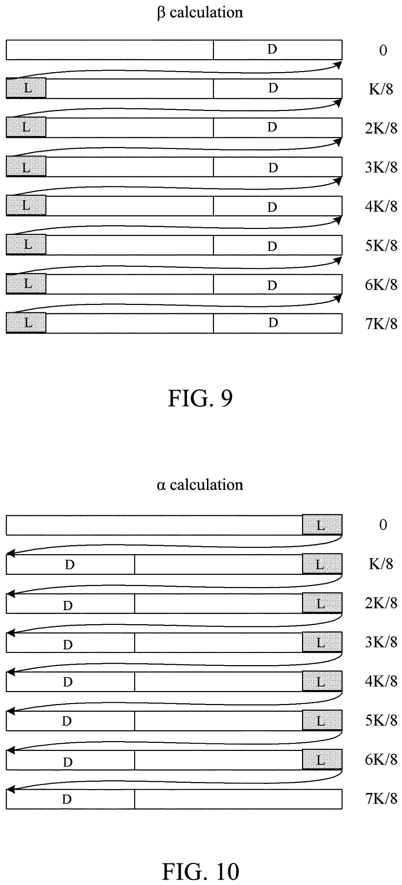

After the calculations in the above steps 1) to 6), an optimal decoding of a component decoding of the data frame to be decoded is completed, obtaining the priori information necessary for the next component decoding. Refer to FIG. 9 for the calculation of the backward state vector, and refer to FIG. 10 for the calculation of the forward state vector.

In order to describe the working principle of the method and hardware apparatus for the parallel Turbo decoder proposed in the present invention more clearly, description will be made below with reference to specific examples.

Description will be made below by taking the decoding processes of two code blocks with the lengths of 512 and 1024 respectively as examples.

Suppose the internal input memory (including system soft bit memory, and check soft bit memories 1 and 2) is null at the beginning, so both of the ping-memory and pong-memory are set to be null, then the code block with the length of 512 is allowed to input, N is adaptively selected as N=1 according to the length 512 of the code block, accordingly, only the first small memories of the system soft bit memory, and check soft bit memories 1 and 2 are activated, i.e., all data are written into the ping-memory space (i.e., the space whose base address is 0) of the first small memories. After input data are completely written, the ping-memory data are set to be valid, and the ping-memory is set to be not allowing write, waiting for decoding. Afterwards, when it is judged that the parallel MAP processing is idle, the decoding process is activated. If the second data block with the length of 1024 arrives, the state of the input memory at this moment is judged, and since the pong-memory is null and thus allows writing, N is adaptively selected as N=2 according to the length 1024 of the code block, the first and second small memories of the system soft bit memory, and check soft bit memories 1 and 2 are activated, i.e., the former 512 data of the data are written into the pong-memory space (i.e., the space whose base address is 768) of the first small memories, and the latter 512 data of the data are written into the pong-memory space of the second small memories. The pong-memory data are set to be valid, and the pong-memory is set to be not allowing write, waiting for decoding.

After the data block with the length of 512 is completely written and the memory is set to be valid, decoding of this code block is initiated when the MAP processing unit is idle, and the parallel processing MAP unit is set to be busy. Since N=1 at this moment, only the first MAP calculating unit is activated. Iteration calculation is implemented according to the working process of the MAP calculating unit, until the set number of iterations is achieved or the ending condition is met, at which moment, the decoding of the current code block is ended. After the decoding of the code block is over, the parallel processing MAP unit is set to be idle, meanwhile the corresponding input memory is set to allow writing, i.e., be in null state.

At this moment, as for the second code block waiting for decoding, i.e., the code block with the length of 1024, since the conditions that the memory data are valid and the parallel processing MAP unit is idle are both satisfied, the decoding process of the code block with a length of 1024 is initiated, meanwhile, parameters (length of the code block, the number of iterations) are updated. Since N=2, the first and second MAP calculating units are activated, these two MAP calculating units read data from the input memory and the priori information memories in parallel to implement MAP calculation. When the set number of the iterations is achieved or the ending condition is met, the decoding process of the current code block is ended. After the decoding of the code block is over, the parallel processing MAP unit is set to be idle, meanwhile the corresponding input memory is set to allow writing, i.e., be in null state.

The same process is performed for other code blocks, and the above process is repeated if a new code block is input. In the present invention, the value of N is adaptively selected based on the length of the input code block, a corresponding number of MAP calculating units and the corresponding memories are activated to perform parallel iteration decoding. Meanwhile, inside each MAP calculating unit, it is to make full use of parallel processing and pipeline techniques to accelerate the decoding process, thereby shortening the decoding delay as much as possible and increasing the data throughput rate of the decoder.

Therefore, the Turbo parallel decoding method and the corresponding hardware apparatus provided by the present invention have an efficient decoding performance, and can well satisfy the real-time processing performance requirement of low delay and high throughput rate in a LTE system.

Industrial Applicability

The present invention is designed to adopt adaptive segmenting parallel sliding window log-MAP algorithm to implement Turbo decoding. The adaptive segmenting parallel sliding window log-MAP algorithm is a modification and improvement made on the log-MAP algorithm and sliding window algorithm, and it can support parallel operation, thereby reducing decoding delay and increasing decoding rate. By properly selecting the parameters D and L of the sliding window, the adaptive segmenting parallel sliding window log-MAP algorithm can increase decoding rate several times with the less smaller implementation scale and memory capacity, and thus is particularly suitable for FPGA/ASIC hardware to realize a high-speed Turbo decoder so as to meet the performance requirement for a LTE system.

**Claims**

1. A decoding apparatus for parallel Turbo decoding in LTE, comprising: an input storage module, a processing module, a control module and an output module, wherein:

   the input storage module is adapted to implement the following operations under control of the control module: dividing an input frame to be decoded into blocks, storing each block respectively as system soft bits; storing input check soft bits; receiving and storing priori information output by a processing unit; and in a component decoding process, outputting the priori information, system soft bits and check soft bits required by the processing unit for calculation;
   the processing module is adapted to simultaneously perform component decoding once for a plurality of blocks of the frame to be decoded, and in said component decoding process, divide each block into a plurality of sliding windows according to a sliding window algorithm, and calculate following parameters according to the system soft bits, the check soft bits and priori information: branch metric value $\gamma$, forward state vector $\alpha$, backward state vector $\beta$, log-likelihood ratio (LLR), and priori information, outputting the priori information to the input storage module to store, completing a iteration process after performing component decoding a plurality of times, and transmitting the log-likelihood ratio (LLR) to the output module;
   the control module is adapted to control and coordinate operation of each module, generate control signals of the component decoding process and the iteration process of the processing module, generate input storage module control signals, generate output module control signals, and enable the input storage module and the processing module to proceed with iteration decoding process or stop the iteration decoding process according to feedback signals of the output module;
   the output module is adapted to perform a hard decision on the log-likelihood ratio (LLR), judge whether a result of the hard decision meets an iteration ending condition, output the feedback signals to the control module, and output a decoding iteration calculation result as a decoding result when the calculation result meets the ending condition;
   wherein, the input storage module includes an input memory controller unit, a priori information memory unit, a system soft bit memory unit and a check soft bit memory unit, wherein:

      the input memory controller unit is adapted to generate read-write control signals of each memory, divide a data frame to be decoded into blocks according to a number of blocks determined by the control module and then store the blocks in the system soft bit memory unit;
      the check soft bit memory unit is adapted to store input check soft bits, and includes a first check soft bit memory, a second check soft bit memory and a first multiplexer, wherein the first check soft bit memory outputs a first check soft bit to an input end of the first multiplexer, the second check soft bit memory outputs a second check soft bit to another input end of the first multiplexer, and a control end of the first multiplexer is connected to the control module; the first multiplexer controls, according to the control signals of the control module, to select the first check soft bit and the second check soft bit as input data respectively in a first component decoding operation and a second component decoding operation;
      the system soft bit memory unit is adapted to respectively store each block of the input divided frame to be decoded; the system soft bit memory unit includes a system soft bit memory, a first interleaver and a second multiplexer, wherein the system soft bit memory has two output ends, one output end of the system soft bit memory outputs data directly to an input end of the second multiplexer, and data output by another output end of the system soft bit memory are interleaved by the first interleaver and then input to another input end of the second multiplexer, and a control end of the second multiplexer is connected to the control module; the second multiplexer is used to output the system soft bits to the processing module in the first component decoding according to the control signals of the control module, and to output interleaved system soft bits to the processing module in the second component decoding;

the priori information memory unit is adapted to respectively store results from a plurality of component decoding processes, and includes a first priori information memory, a second priori information memory, a first interleaver and a third multiplexer, wherein first priori information output by the first priori information memory is interleaved by the interleaver and then input to an input end of the third multiplexer; the second priori information memory outputs second priori information to another input end of the third multiplexer; a control end of the third multiplexer is connected to the control module; the third multiplexer is adapted to selectively output the second priori information and the interleaved first priori information to the processing module according to the control signals of the control module;

wherein, the processing module includes a parallel processing MAP unit, a fourth multiplexer and a second interleaver, wherein the parallel processing MAP unit receives data output by the input storage module, after performing component decoding processing and iteration processing a plurality of times, completes a decoding process and outputs a decoding result to an input end of the fourth multiplexer, a control end of the fourth multiplexer is connected to the control module, the fourth multiplexer controls, according to the control signals of the control module, to output the first priori information to the first priori information memory in the first component decoding, and output the second priori information to the second interleaver in the second component decoding, the second interleaver outputs one channel of the interleaved second priori information to the second priori information memory and outputs another channel of the interleaved second priori information to the output module.

2. The apparatus according to claim 1, wherein,
the system soft bit memory, the first check soft bit memory, and the second check soft bit memory are respectively composed of a plurality of independent small memories which can be read in parallel and written serially, and write addresses of which are in succession; the first priori information memory and the second priori information memory are respectively composed of a plurality of independent small memories which can be read and written in parallel, and write addresses of which are in succession.

3. The apparatus according to claim 2, wherein,
the system soft bit memory, the first check soft bit memory, the second check soft bit memory, the first priori information memory and the second priori information memory all support ping-pong operation, each memory is composed of eight small memories, and size of each small memory is 1536 bytes.

4. The apparatus according to claim 1, wherein,
each parallel processing MAP units includes a plurality of independent MAP calculating units used to implement parallel component decoding, each MAP calculating unit is composed of a first $\gamma$ calculating unit, a $\beta$ calculating unit, a $\beta$ memory, a second $\gamma$ calculating unit, an $\alpha$ calculating unit, and an LLR calculating unit, wherein:

the first $\gamma$ calculating unit performs branch metric value calculation for calculating $\beta$, and inputs the calculated branch metric value for backward use to the $\beta$ calculating unit; the second $\gamma$ calculating unit performs branch metric value calculation for calculating $\alpha$, and inputs the calculated branch metric value for forward use to the $\alpha$ calculating unit; the $\beta$ calculating unit is used to calculate a backward state vector $\beta$; the $\beta$ memory is used to store the calculated $\beta$; the $\alpha$ calculating unit is used to calculate a forward state vector $\alpha$; the LLR calculating unit is used to calculate log-likelihood ratio and priori information.

5. The apparatus according to claim 4, wherein,
the LLR calculating unit includes: a group of sixteen three-input adders, and a first group of eight max* calculating units, a second group of four max* calculating units, a third group of two max* calculating units, and a subtracter; wherein, two adjacent three-input adders work as a sub-group to perform addition operation, outputting eight addition values in total to the eight max* calculating units in the first group of max* calculating units respectively; in the first group of max* calculating units, two adjacent max* calculating units work as a sub-group to perform max* calculation, outputting four results in total to the four max* calculating units in the second group of max* calculating units respectively; in the second group of max* calculating units, two adjacent max* calculating units works as a sub-group to perform max* calculation, outputting two results to the subtracter, getting the difference by the subtracter to obtain the log-likelihood ratio (LLR), and new priori information is obtained according to the log-likelihood ratio, and system information and priori information input at this time.

6. The apparatus according to claim 1, wherein,
the output module includes a hard decision unit, an iteration ending judging unit and an output memory controller unit, wherein, the hard decision unit receives priori information output by the processing module, sends the priori information to the iteration ending judging unit and the output memory controller unit respectively, the iteration ending judging unit judges whether a result of the hard decision meets the ending condition, and outputs to the control module a feedback signal indicating that the condition is met or the condition is not met; when the ending condition is met, the control module sends an output signal to the output memory controller unit, and the output memory controller unit outputs the decoding result.

7. The apparatus according to claim 6, wherein,
it is believed that the iteration condition is met if the iteration ending judging unit judges that the decoding result meets any one of following conditions: reaching a set number of iterations; judging that a Cyclic Redundancy Check (CRC) calculation result of decoded block data is correct.

8. A method for parallel Turbo decoding in a LTE system being carried out by the decoding apparatus as defined in any of claims 1-7, comprising following steps of:

storing input check soft bits and a frame to be decoded, and when storing said frame to be decoded, dividing the frame to be decoded into blocks and storing each block respectively as system soft bits; simultaneously performing component decoding once for a plurality of blocks of the frame to be decoded, and in a component decoding process, dividing each block into a plurality of sliding windows according to a sliding window algorithm, and calculating following parameters according to the system soft bits, check soft bits and priori information: branch metric value $\gamma$, forward state vector $\alpha$, backward state vector $\beta$, log-likelihood ratio (LLR), and priori information, and storing the priori information for use in a next component decoding process; completing a decoding process after performing component decoding a plurality of times; performing a hard decision on the LLR, judging whether a result of the hard decision meets an iteration ending condition, if yes, outputting a decoding result, otherwise, proceeding with a next iteration decoding process.

9. The method according to claim 8, wherein,
a decoding process includes performing component decoding two times, and in one decoding process, a first component decoding is implemented according to the system soft bits, second priori information obtained in a last component decoding and a first check soft bit; a second component decoding is implemented according to the system soft bits, a first priori information obtained in a last component decoding and a second check soft bit; the priori information in the first component decoding in an initial first decoding process is 0.

10. The method according to claim 8, wherein,
it is believed that the iteration ending condition is met and the iteration will be ended as long as the decoding result meets any one of following conditions: reaching a set number of iterations; judging that a Cyclic Redundancy Check (CRC) calculation result of decoded block data is correct.

11. The method according to claim 8, wherein,
a number N of the blocks is determined according to a length K of the frame to be decoded: when $K \leq 512$, N=1; when $512 < K \leq 1024$, N=2; when $1024 < K \leq 2048$, N=4; when $2048 < K \leq 6144$, N=8.

12. The method according to claim 8, wherein,
in a process of performing calculation on a certain block according to a sliding window algorithm, the block is divided into a plurality of sliding windows, wherein:

when calculating a backward state vector $\beta$ of a first sliding window: a value of $\beta$ is calculated after L recursions by taking 0 as an initial value, and then this value of $\beta$ is used as an initial value to perform D recursion calculations, obtaining D values of $\beta$ in turn, which are used as the values of $\beta$ of the first sliding window; when calculating the backward state vector $\beta$ of a last sliding window, if the block where the sliding window is located is the last block, the value of $\beta$ of the last sliding window is obtained by performing D recursion calculations, taking 0 as an initial value; if the block where the sliding window is located is not the last block, a value of $\beta$ is calculated after L recursions by taking 0 as an initial value firstly, and then this value of $\beta$ is used as an initial value to perform D recursion calculations to obtain the value of $\beta$ of the last sliding window;

when calculating a forward state vector $\alpha$ of the first sliding window, if the block where the sliding window is located is the first block, then the value of $\alpha$ of this first sliding window is obtained by performing D recursion calculations, taking 0 as an initial value; if the block where the sliding window is located is not the first block, a value of $\alpha$ is calculated after L recursions by taking 0 as an initial value firstly, and then the value of $\alpha$ is used as an initial value to perform D recursion calculations to obtain the value of $\alpha$ of the first sliding window;

when calculating a forward state vector $\alpha$ of the last sliding window, a value of $\alpha$ is calculated after L recursions by taking 0 as an initial value, and then this value of $\alpha$ is used as an initial value to perform D recursion calculations, obtaining D values of $\alpha$ in turn, which are used as the values of $\alpha$ of the first sliding window; wherein, $1 \leq L \leq D$.

**13.** The method according to claim 8, wherein,
the log-likelihood ratio (LLR) is calculated while calculating the forward state vector $\alpha$.

**Patentansprüche**

**1.** Decodiervorrichtung zur parallelen Turbo-Decodierung in LTE, umfassend: ein Eingabespeichermodul, ein Verarbeitungsmodul, ein Steuermodul und ein Ausgabemodul, worin:

das Eingabespeichermodul dafür geeignet ist, die folgenden Operationen, unter Kontrolle des Steuermoduls, zu implementieren: Einteilen eines zu decodierenden Eingaberahmens in Blöcke, indem jeder Block jeweils als System-Softbits gespeichert wird; Speichern von Eingabe-Prüf-Softbits; Empfangen und Speichern von A-priori-Informationen, die von einer Verarbeitungseinheit ausgegeben werden; und in einem Komponenten-Decodierprozess, Ausgeben der A-priori-Informationen, der System-Softbits und der Prüf-Softbits, die von der Verarbeitungseinheit zur Berechnung gefordert werden;

das Verarbeitungsmodul dafür geeignet ist, Komponenten-Decodierung einmal für eine Vielzahl von Blöcken des zu decodierenden Rahmens gleichzeitig durchzuführen, und in diesem Komponenten-Decodierprozess, jeden Block in eine Vielzahl von gleitenden Fenstern aufgrund eines gleitenden Fensteralgorithmus einzuteilen, und die folgenden Parameter aufgrund der System-Softbits, der Prüf-Softbits und der A-priori-Informationen zu berechnen: Zweigmetrikwert $\gamma$, Vorwärtszustandsvektor $\alpha$, Rückwärtszustandsvektor $\beta$, Log-Likelihood-Verhältnis (LLR) und A-priori-Informationen, indem die A-priori-Informationen an das Eingabespeichermodul zur Speicherung ausgegeben werden, ein Iterationsprozess nach Durchführung einer Komponenten-Decodierung eine Vielzahl von Malen beendet wird und das Log-Likelihood-Verhältnis (LLR) auf das Ausgabemodul übertragen wird;

das Steuermodul dafür geeignet ist, die Operation jedes Moduls zu steuern und zu koordinieren, Steuersignale des Komponenten-Decodierprozesses und des Iterationsprozesses des Verarbeitungsmoduls zu erzeugen, Eingabespeichermodulsteuersignale zu erzeugen, Ausgabemodulsteuersignale zu erzeugen, und zu ermöglichen, dass das Eingabespeichermodul und das Verarbeitungsmodul mit dem Iterationsdecodierprozess fortfahren oder den Iterationsdecodierprozess stoppen, je nach Rückmeldungssignalen des Ausgabemoduls;

das Ausgabemodul dafür geeignet ist, eine harte Entscheidung über das Log-Likelihood-Verhältnis (LLR) zu treffen, zu beurteilen, ob ein Ergebnis der harten Entscheidung eine Iterationsbeendigungsbedingung erfüllt, die Rückmeldungssignale an das Ausgabemodul auszugeben, und ein Decodierungsiterationsberechnungsergebnis als ein Decodierungsergebnis dann auszugeben, wenn das Berechnungsergebnis die Beendigungsbedingung erfüllt;

worin das Eingabespeichermodul eine Eingabespeichersteuerungseinheit, eine A-priori-Informationsspeichereinheit, eine System-Soft-Bit-Speichereinheit und eine Prüf-Soft-Bit-Speichereinheit umfasst, worin:

die Eingabespeichersteuerungseinheit dafür geeignet ist, Lese-Schreib-Steuersignale jedes Speichers zu erzeugen, einen zu decodierenden Datenrahmen in Blöcke je nach einer Anzahl von Blöcken einzuteilen, die vom Steuermodul bestimmt wird, und dann die Blöcke in der System-Soft-Bit-Speichereinheit zu speichern;

die Prüf-Soft-Bit-Speichereinheit dafür geeignet ist, Eingabe-Prüf-Soft-Bits zu speichern, und einen ersten Prüf-Soft-Bit-Speicher, einen zweiten Prüf-Soft-Bit-Speicher und einen ersten Multiplexer umfasst, worin der erste Prüf-Soft-Bit-Speicher ein erstes Prüf-Soft-Bit an ein Eingabeende des ersten Multiplexers ausgibt, der zweite Prüf-Soft-Bit-Speicher ein zweites Prüf-Soft-Bit an ein anderes Eingabeende des ersten Multiplexers ausgibt, und ein Steuerende des ersten Multiplexers mit dem Steuermodul verbunden ist; der erste Multiplexer, je nach den Steuersignalen des Steuermoduls, steuert, das erste Prüf-Soft-Bit und das zweite Prüf-Soft-Bit als Eingabedaten jeweils in einer ersten Komponenten-Decodieroperation und in einer zweiten Komponenten-Decodieroperation auszuwählen;

die System-Soft-Bit-Speichereinheit dafür geeignet ist, jeden Block des zu decodierenden eingeteilten Eingaberahmens jeweils zu speichern; die System-Soft-Bit-Speichereinheit einen System-Soft-Bit-Speicher, einen ersten Interleaver und einen zweiten Multiplexer umfasst, worin der System-Soft-Bit-Speicher zwei Ausgabeenden aufweist, ein Ausgabeende des System-Soft-Bit-Speichers Daten direkt an ein Eingabeende des zweiten Multiplexers ausgibt, und die Daten, die von einem anderen Ausgabeende des System-Soft-Bit-Speichers ausgegeben werden, vom ersten Interleaver verschachtelt werden und dann an ein anderes Eingabeende des zweiten Multiplexers eingegeben werden, und ein Steuerende des zweiten Multiplexers mit dem Steuermodul verbunden ist; der zweite Multiplexer benutzt wird, um die System-Soft-Bits an das Verarbeitungsmodul in der ersten Komponenten-Decodierung je nach den Steuersignalen des Steuermoduls auszugeben und verschachtelte System-Soft-Bits an das Verarbeitungsmodul in der zweiten Komponenten-Decodierung auszugeben;

die A-priori-Informationsspeichereinheit dafür geeignet ist, Ergebnisse aus einer Vielzahl von Komponenten-Decodierprozessen jeweils zu speichern, und einen ersten A-priori-Informationsspeicher, einen zweiten A-priori-Informationsspeicher, einen ersten Interleaver und einen dritten Multiplexer umfasst, worin die ersten A-priori-Informationen, die von dem ersten A-priori-Informationsspeicher ausgegeben werden, vom Interleaver verschachtelt werden und dann an ein Eingabeende des dritten Multiplexers eingegeben werden; der zweite A-priori-Informationsspeicher zweite A-priori-Informationen an ein anderes Eingabeende des dritten Multiplexers ausgibt; ein Steuerende des dritten Multiplexers mit dem Steuermodul verbunden ist; der dritte Multiplexer dafür geeignet ist, die zweiten A-priori-Informationen und die verschachtelten ersten A-priori-Informationen an das Verarbeitungsmodul je nach den Steuersignalen des Steuermoduls selektiv auszugeben;

worin das Verarbeitungsmodul eine parallele MAP-Verarbeitungseinheit, einen vierten Multiplexer und einen zweiten Interleaver umfasst, worin die parallele MAP-Verarbeitungseinheit Daten empfängt, die vom Eingabespeichermodul ausgegeben werden, nach Durchführung einer Komponenten-Decodierverarbeitung und Iterationsverarbeitung eine Vielzahl von Malen, einen Decodierprozess beendet und ein Decodierungsergebnis an ein Eingabeende des vierten Multiplexers ausgibt, ein Steuerende des vierten Multiplexers mit dem Steuermodul verbunden ist, der vierte Multiplexer, je nach den Steuersignalen des Steuermoduls, steuert, die ersten A-priori-Informationen an den ersten A-priori-Informationsspeicher in der ersten Komponenten-Decodierung auszugeben, und die zweiten A-priori-Informationen an den zweiten Interleaver in der zweiten Komponenten-Decodierung auszugeben, der zweite Interleaver einen Kanal der verschachtelten zweiten A-priori-Informationen an den zweiten A-priori-Informationsspeicher ausgibt und einen anderen Kanal der verschachtelten zweiten A-priori-Informationen an das Ausgabemodul ausgibt.

2. Vorrichtung nach Anspruch 1, worin
der System-Soft-Bit-Speicher, der erste Prüf-Soft-Bit-Speicher und der zweite Prüf-Soft-Bit-Speicher jeweils aus einer Vielzahl von unabhängigen kleinen Speichern bestehen, die parallel gelesen und seriell geschrieben werden können, und deren Schreibadressen nacheinander folgen; der erste A-priori-Informationsspeicher und der zweite A-priori-Informationsspeicher jeweils aus einer Vielzahl von unabhängigen kleinen Speichern bestehen, die parallel gelesen und geschrieben werden können, und deren Schreibadressen nacheinander folgen.

3. Vorrichtung nach Anspruch 2, worin
der System-Soft-Bit-Speicher, der erste Prüf-Soft-Bit-Speicher, der zweite Prüf-Soft-Bit-Speicher, der erste A-priori-Informationsspeicher und der zweite A-priori-Informationsspeicher alle eine Ping-Pong-Operation unterstützen, jeder Speicher aus acht kleinen Speichern besteht, und die Größe jedes kleinen Speichers 1536 Bytes beträgt.

4. Vorrichtung nach Anspruch 1, worin
jede parallele MAP-Verarbeitungseinheit eine Vielzahl von unabhängigen MAP-Berechnungseinheiten umfasst, die benutzt werden, um eine parallele Komponentendecodierung zu implementieren, wobei jede MAP-Berechnungseinheiten aus einer ersten $\gamma$-Berechnungseinheit, aus einer $\beta$-Berechnungseinheit, einem $\beta$-Speicher, einer zweiten $\gamma$-Berechnungseinheit, einer $\alpha$-Berechnungseinheit und einer LLR-Berechnungseinheit besteht, worin:

die erste $\gamma$-Berechnungseinheit Zweigmetrikwertberechnung zur Berechnung von $\beta$ durchführt, und den berechneten Zweigmetrikwert zur Rückwärtsbenutzung an die $\beta$-Berechnungseinheit eingibt; die zweite $\gamma$-Berechnungseinheit Zweigmetrikwertberechnung zur Berechnung von $\alpha$ durchführt, und den berechneten Zweigmetrikwert zur Vorwärtsbenutzung an die $\alpha$-Berechnungseinheit eingibt; die $\beta$-Berechnungseinheit benutzt wird, um einen Rückwärtszustandsvektor $\beta$ zu berechnen; der $\beta$-Speicher benutzt wird, um den berechneten $\beta$ zu speichern; die $\alpha$-Berechnungseinheit benutzt wird, um einen Vorwärtszustandsvektor $\alpha$ zu berechnen; die LLR-Berechnungseinheit benutzt wird, um Log-Likelihood-Verhältnis und A-priori-Informationen zu berechnen.

5. Vorrichtung nach Anspruch 4, worin
die LLR-Berechnungseinheit umfasst: eine Gruppe von sechzehn Addierern mit drei Eingängen und eine erste Gruppe von acht max* Berechnungseinheiten, eine zweite Gruppe von vier max* Berechnungseinheiten, eine dritte Gruppe von zwei max* Berechnungseinheiten, und einen Subtrahierer; worin zwei benachbarte Addierer mit drei Eingängen als eine Untergruppe arbeiten, um eine Additionsoperation durchzuführen, indem acht Additionswerte insgesamt an die acht max* Berechnungseinheiten in der ersten Gruppe von max* Berechnungseinheiten jeweils ausgegeben werden; in der ersten Gruppe von max* Berechnungseinheiten zwei benachbarte max* Berechnungseinheiten als eine Untergruppe arbeiten, um max* Berechnung durchzuführen, indem vier Ergebnisse insgesamt an die vier max* Berechnungseinheiten in der zweiten Gruppe von max* Berechnungseinheiten jeweils ausgegeben werden; in der zweiten Gruppe von max* Berechnungseinheiten zwei benachbarte max* Berechnungseinheiten als eine Untergruppe arbeiten, um max* Berechnung durchzuführen, indem zwei Ergebnisse an den Subtrahierer ausgegeben werden, indem die Differenz vom Subtrahierer erhalten wird, um das Log-Likelihood-Verhältnis (LLR) zu erhalten, und neue A-priori-Informationen aufgrund des Log-Likelihood-Verhältnisses, und der System-Informationen und der A-priori-Informationen erhalten werden, die zu diesem Zeitpunkt eingegeben sind.

6. Vorrichtung nach Anspruch 1, worin
das Ausgabemodul eine harte Entscheidungseinheit, eine Iterationsbeendigungsbeurteilungseinheit und eine Ausgabespeichersteuereinheit umfasst, worin die harte Entscheidungseinheit A-priori-Informationen empfängt, die vom Verarbeitungsmodul ausgegeben werden, die A-priori-Informationen jeweils an die Iterationsbeendigungsbeurteilungseinheit und an die Ausgabespeichersteuereinheit sendet, die Iterationsbeendigungsbeurteilungseinheit beurteilt, ob ein Ergebnis der harten Entscheidung die Beendigungsbedingung erfüllt, und an das Steuermodul ein Rückmeldungssignal ausgibt, das anzeigt, dass die Bedingung erfüllt ist oder dass die Bedingung nicht erfüllt ist; wenn die Beendigungsbedingung erfüllt ist, das Steuermodul ein Ausgabesignal an die Ausgabespeichersteuereinheit sendet, und die Ausgabespeichersteuereinheit das Decodierungsergebnis ausgibt.

7. Vorrichtung nach Anspruch 6, worin
es angenommen wird, dass die Iterationsbedingung dann erfüllt ist, wenn die Iterationsbeendigungsbeurteilungseinheit beurteilt, dass das Decodierungsergebnis irgendeine der folgenden Bedingungen erfüllt: Erzielen einer angegebenen Anzahl von Iterationen; Beurteilen, dass ein zyklisches Redundanzprüfungs(CRC)-Berechnungsergebnis von decodierten Blockdaten richtig ist.

8. Verfahren zur parallelen Turbo-Decodierung in einem LTE-System, das von der Decodiervorrichtung nach einem der Ansprüche 1-7 durchgeführt wird, umfassend die folgenden Schritte von:

Speichern von Eingabe-Prüf-Softbits und von einem zu decodierenden Rahmen, und, wenn dieser zu decodierende Rahmen gespeichert wird, Einteilen des zu decodierenden Rahmens in Blöcke und Speichern jedes Blocks jeweils als System-Softbits; zur gleichen Zeit Durchführen von Komponenten-Decodierung einmal für eine Vielzahl von Blöcken des zu decodierenden Rahmens, und in diesem Komponenten-Decodierprozess Einteilen jedes Blocks in eine Vielzahl von gleitenden Fenstern aufgrund eines gleitenden Fensteralgorithmus, und Berechnen der folgenden Parameter aufgrund der System-Softbits, der Prüf-Softbits und der A-priori-Informationen: Zweigmetrikwert $\gamma$, Vorwärtszustandsvektor $\alpha$, Rückwärtszustandsvektor $\beta$, Log-Likelihood-Verhältnis (LLR) und A-priori-Informationen, und Speichern der A-priori-Informationen zur Benutzung in einem nächsten Komponenten-Decodierprozess; Beenden eines Decodierprozesses nach Durchführung einer Komponenten-Decodierung eine Vielzahl von Malen; Treffen einer harten Entscheidung über das LLR, Beurteilen, ob ein Ergebnis der harten Entscheidung eine Iterationsbeendigungsbedingung erfüllt, wenn ja, Ausgeben eines Decodierungsergebnisses, ansonsten, Fortfahren mit einem nächsten Iterationsdecodierprozess.

9. Verfahren nach Anspruch 8, worin
ein Decodierprozess das Durchführen eines Decodierprozesses zweimal umfasst, und in einem Decodierprozess, ein erstes Komponenten-Decodieren aufgrund der System-Soft-Bits, der zweiten A-priori-Informationen, die in einem letzten Komponenten-Decodieren erhalten werden, und eines ersten Prüf-Soft-Bits implementiert wird; ein zweites Komponenten-Decodieren aufgrund der System-Soft-Bits, erster A-priori-Informationen, die in einem letzten Komponenten-Decodieren erhalten werden, und eines zweiten Prüf-Soft-Bits implementiert wird; die A-priori-Informationen in dem ersten Komponenten-Decodieren in einem anfänglichen ersten Decodierprozess 0 sind.

10. Verfahren nach Anspruch 8, worin
es angenommen wird, dass die Iterationsbeendigungsbedingung erfüllt ist und dass die Iteration beendet werden wird, solange das Decodierungsergebnis irgendeine der folgenden Bedingungen erfüllt: Erzielen einer angegebenen Anzahl von Iterationen; Beurteilen, dass ein zyklisches Redundanzprüfungs(CRC)-Berechnungsergebnis von decodierten Blockdaten richtig ist.

11. Verfahren nach Anspruch 8, worin
eine Anzahl N der Blöcke aufgrund einer Länge K des zu decodierenden Rahmens bestimmt wird: wenn $K \leq 512$, N=1; wenn $512 < K \leq 1024$, N=2; wenn $1024 < K \leq 2048$, N=4; wenn $2048 < K \leq 6144$, N=8.

12. Verfahren nach Anspruch 8, worin
in einem Prozess von Durchführen einer Berechnung an einem bestimmten Block aufgrund eines gleitenden Fensteralgorithmus, der Block in eine Vielzahl von gleitenden Fenstern eingeteilt wird, worin:

wenn ein Rückwärtszustandsvektor $\beta$ eines ersten gleitenden Fensters berechnet wird: ein Wert von $\beta$ nach L Rekursionen berechnet wird, indem 0 als Anfangswert genommen wird, und dann dieser Wert von $\beta$ als Anfangswert benutzt wird, um D Rekursionsberechnungen durchzuführen, indem D Werte von $\beta$ ihrerseits erhalten werden, die als die Werte von $\beta$ des ersten gleitenden Fensters benutzt werden;
wenn der Rückwärtszustandsvektor $\beta$ eines letzten gleitenden Fensters berechnet wird, wenn der Block, wo das gleitende Fenster befindlich ist, der letzte Block ist, der Wert von $\beta$ des letzten gleitenden Fensters dadurch erhalten wird, dass D Rekursionsberechnungen durchgeführt werden, indem 0 als Anfangswert genommen wird; wenn der Block, wo das gleitende Fenster befindlich ist, nicht der letzte Block ist, ein Wert von $\beta$ nach L Rekursionen berechnet wird, indem 0 als Anfangswert zunächst genommen wird, und dann dieser Wert von $\beta$ als Anfangswert benutzt wird, um D Rekursionsberechnungen durchzuführen, um den Wert von $\beta$ des letzten gleitenden Fensters zu erhalten;
wenn ein Vorwärtszustandsvektor $\alpha$ des ersten gleitenden Fensters berechnet wird, wenn der Block, wo das gleitende Fenster befindlich ist, der erste Block ist, der Wert von $\alpha$ dieses ersten gleitenden Fensters dadurch erhalten wird, dass D Rekursionsberechnungen durchgeführt werden, indem 0 als Anfangswert genommen wird; wenn der Block, wo das gleitende Fenster befindlich ist, nicht der erste Block ist, ein Wert von $\alpha$ nach L Rekursionen berechnet wird, indem 0 als Anfangswert zunächst genommen wird, und dann der Wert von $\alpha$ als Anfangswert benutzt wird, um D Rekursionsberechnungen durchzuführen, um den Wert von $\alpha$ des ersten gleitenden Fensters zu erhalten;
wenn ein Vorwärtszustandsvektor $\alpha$ des letzten gleitenden Fensters berechnet wird, ein Wert von $\alpha$ nach L Rekursionen berechnet wird, indem 0 als Anfangswert genommen wird, und dann dieser Wert von $\alpha$ als Anfangswert benutzt wird, um D Rekursionsberechnungen durchzuführen, indem D Werte von $\alpha$ ihrerseits erhalten werden, die als die Werte von $\alpha$ des ersten gleitenden Fensters benutzt werden; worin $1 \leq L \leq D$.

13. Verfahren nach Anspruch 8, worin
das Log-Likelihood-Verhältnis (LLR) dann berechnet wird, während der Vorwärtszustandsvektor $\alpha$ berechnet wird.

## Revendications

1. Appareil de décodage pour décodage turbo en parallèle dans un système à technologie d'évolution à long terme (LTE), comprenant : un module de stockage d'entrée, un module de contrôle et un module de sortie, dans lequel :

le module de stockage d'entrée est apte à mettre en oeuvre les opérations suivantes sous le contrôle du module de contrôle : division d'une trame d'entrée à décoder en blocs, stockage de chaque bloc respectivement en tant que bits système souples; stockage de bits souples de vérification d'entrée ; réception et stockage d'une sortie d'informations à priori par une unité de traitement ; et dans un processus de décodage de composant, émission des informations à priori, des bits système souples et des bits souples de vérification nécessaires à l'unité de processus pour le calcul ;
le module de traitement est apte à effectuer le décodage de composant une fois pour une pluralité de blocs de la trame à décoder et, dans ledit processus de décodage de composant, à diviser chaque bloc en plusieurs fenêtres dynamiques en fonction d'un algorithme de fenêtre dynamique, et à calculer les paramètres suivants en fonction des bits système souples, des bits souples de vérification et des informations a priori : valeur de mesure de branche γ, mesure d'état avant α, mesure d'état inverse β, logarithme du rapport de vraisemblance (LLR), et informations a priori, à émettre les informations a priori à stocker au module de stockage d'entrée, à compléter un processus par itération après avoir effectué le décodage de composant une pluralité de fois, et à transmettre le logarithme du rapport de vraisemblance (LLR) au module de sortie ;

le module de contrôle est apte à contrôler et à coordonner l'opération de chaque module, à générer des signaux de contrôle du processus de décodage de composant et du processus d'itération du module de traitement, à générer des signaux de contrôle de module de stockage d'entrée, à générer des signaux de contrôle du module de sortie, et à permettre au module de stockage d'entrée et au module de traitement de procéder avec le processus de décodage par itération ou d'arrêter le processus de décodage d'itération en réponse aux signaux de rétroaction du module de sortie ;

le module de sortie est apte à réaliser une décision binaire sur le logarithme du rapport de vraisemblance (LLR), à déterminer si un résultat de la décision binaire répond à une condition d'arrêt de l'itération, à émettre des signaux de rétroaction au module de contrôle, et à émettre un résultat d'un calcul d'itération de décodage comme résultat de décodage, lorsque le résultat du calcul répond à la condition d'arrêt ;

dans lequel le module de stockage d'entrée comprend une unité contrôleur de mémoire d'entrée, une unité de mémoire d'informations a priori, une unité de mémoire de bits système souples, et une unité de mémoire de bits souples de vérification, dans lequel :

l'unité contrôleur de mémoire d'entrée est apte à générer des signaux de contrôle de lecture-écriture, à diviser en blocs une trame de données à décoder suivant un nombre de blocs déterminé par le module de contrôle et ensuite à stocker les blocs dans l'unité de mémoire deux dites système souples ;

l'unité de mémoire de bits souples de vérification est apte à stocker des bits souples de vérification et comprend une première mémoire de bits souples de vérification, une deuxième mémoire de bits souples de vérification, et un premier multiplexeur, dans lequel la première mémoire de bits souples de vérification produit un premier bit souple de vérification pour une extrémité d'entrée du premier multiplexeur, la deuxième mémoire de bits souples de vérification produit un deuxième bit souple de vérification pour une autre extrémité d'entrée du premier multiplexeur, et une extrémité de contrôle du premier multiplexeur est connectée au module de contrôle ; le premier multiplexeur contrôle, suivant les signaux de contrôle du module de contrôle, la sélection du premier bit souple de vérification et du deuxième bit souple de vérification, comme données d'entrée, respectivement dans une première opération de décodage de composant et une deuxième opération de décodage de composant ;

l'unité de mémoire de bits système souple apte à stocker respectivement chaque bloc de la trame divisée d'entrée à décoder ; l'unité de mémoire de bits système souples comprend une mémoire de bits système souples, un premier entrelaceur et un deuxième multiplexeur, dans lequel la mémoire de bits système souples possède deux extrémités de sortie, une extrémité de sortie de la mémoire de bits système souples produit des données directement pour une extrémité d'entrée du deuxième multiplexeur, et les données produites par une autre extrémité de sortie de la mémoire de bits système souples sont entrelacées par le premier entrelaceur et ensuite introduites dans une autre extrémité d'entrée du deuxième multiplexeur, et une unité de contrôle du deuxième multiplexeur est connectée au module de contrôle ; le deuxième multiplexeur est utilisé pour produire les bits système souples pour le module de traitement dans le premier décodage de composant suivant les signaux de contrôle du module de contrôle, et à produire des bits système entrelacés pour le module de traitement dans le deuxième décodage de composant ;

l'unité de mémoire d'informations a priori est apte à stocker respectivement des résultats d'une pluralité de processus de décodage de composant, et comprend une première mémoire d'informations a priori, une deuxième mémoire d'informations a priori, un premier entrelaceur et un troisième multiplexeur, dans lequel les premières informations à priori produite par la première mémoire d'informations a priori sont entrelacées par l'entrelaceur et ensuite introduites dans une extrémité d'entrée du troisième multiplexeur ; la deuxième mémoire d'informations a priori produit des deuxièmes informations a priori pour une autre extrémité d'entrée du troisième multiplexeur ; une extrémité de contrôle du troisième multiplexeur est connectée au module de contrôle ; le troisième multiplexeur est apte à produire sélectivement les deuxièmes informations a priori et les premières informations entrelacées pour le module de traitement suivant les signaux de contrôle du module de contrôle ;

dans lequel le module de traitement comprend une unité MAP de traitement en parallèle, un quatrième multiplexeur et un deuxième entrelaceur, dans lequel l'unité MAP de traitement en parallèle reçoit des données produites par le module de stockage d'entrée, après l'exécution du traitement de décodage de composant et du traitement d'itération une pluralité de fois, complète un processus de décodage et produit un résultat de décodage pour une extrémité d'entrée du quatrième multiplexeur, une extrémité de contrôle du quatrième multiplexeur est connectée au module de contrôle, le quatrième multiplexeur contrôle, suivant les signaux de contrôle du module de contrôle, la production des premières informations a priori pour la première mémoire d'informations a priori dans le premier décodage de composant, et la production des deuxièmes informations a priori pour le deuxième entrelaceur dans le deuxième décodage de composant, le deuxième entrelaceur produit un canal des deuxièmes informations a priori entrelacées pour la deuxième mémoire d'informations a priori et produit un autre canal des deuxièmes informations a priori entrelacées pour le module de sortie.

2. Appareil selon la revendication 1, dans lequel
la mémoire de bits système souples, la première mémoire de bits souples de vérification, et la deuxième mémoire de bits souples de vérification sont respectivement composés d'une pluralité de petites mémoires indépendantes qui peuvent être lues en parallèle et écrites en série, et dont les adresses d'écriture sont en succession ; la première mémoire d'informations a priori et la deuxième mémoire d'informations a priori sont respectivement composés d'une pluralité de petites mémoires indépendantes qui peuvent être lues et écrites en parallèle, et dont les adresses d'écriture sont en succession.

3. Appareil selon la revendication 2, dans lequel
la mémoire de bits système souples, la première mémoire de bits souples de vérification, la deuxième mémoire de bits souples de vérification, la première mémoire d'informations a priori et la deuxième mémoire d'informations a priori supportent l'opération ping-pong, chaque mémoire est constituée de huit petites mémoires, et la dimension de chaque petite mémoire et de 1536 bytes.

4. Appareil selon la revendication 1, dans lequel
chacune des unités MAP de traitement comprend une pluralité d'unités de calcul MAP indépendantes utilisées pour implémenter le décodage de composant en parallèle, chaque unité de calcul MAP est composée d'une première unité de calcule de $\gamma$, une unité de calcul de $\beta$, une deuxième unité de calcul de $\gamma$, une unité de calcul de $\alpha$ et une unité de calcul de LLR, dans lequel :

la première unité de calcul de $\gamma$ effectue le calcul de la valeur de mesure de branche pour calculer $\beta$, et introduit la valeur de mesure de branche dans l'unité de calcul de $\beta$ pour son utilisation inverse ; la deuxième unité de calcul de $\gamma$ effectue le calcul de la valeur de mesure de branche pour calculer $\alpha$, et introduit la valeur de mesure de branche dans l'unité de calcul de $\alpha$ pour son utilisation inverse ; l'unité de calcul de $\beta$ est utilisée pour calculer un vecteur d'état inverse $\beta$ ; la mémoire de $\beta$ est utilisée pour stocker le $\beta$ calculé; l'unité de calcul de $\alpha$ est utilisée pour calculer un vecteur d'état avant $\alpha$ ; l'unité de calcul de LLR est utilisée pour calculer le logarithme du rapport de vraisemblance et les informations a priori.

5. Appareil selon la revendication 4, dans lequel
l'unité de calcul de LLR comprend : un groupe de seize additionneurs à trois entrées, et un premier groupe de huit unités de calcul max*, un deuxième groupe de quatre unités de calcul max*, un troisième groupe de deux unités de calcul max* et un soustracteur; dans lequel, deux additionneurs adjacents à trois entrées font fonction d'un sous-groupe pour effectuer l'opération d'addition, produisant huit valeurs d'addition en total respectivement pour les huit unités de calcul max* du premier groupe d'unités de calcul ; dans le premier groupe d'unités de calcul max*, deux unités de calcul max* adjacentes font fonction d'un sous-groupe pour effectuer le calcul max*, produisant quatre résultats en total respectivement pour les quatre unités de calcul max* du deuxième groupe d'unités de calcul max* ; dans le deuxième groupe d'unités de calcul max*, deux unités de calcul max* adjacentes font fonction d'un sous-groupe pour effectuer le calcul max*, produisant deux résultats en total pour le soustracteur pour obtenir le logarithme du rapport de vraisemblance (LLR), et des nouvelles informations à priori sont obtenues selon le logarithme du rapport de vraisemblance et les informations de système et les informations a priori introduites en ce moment.

6. Appareil selon la revendication 1, dans lequel
le module de sortie comprend une unité de décision binaire, une unité de détermination d'arrêt d'itération et un contrôleur de mémoire de sortie et dans lequel, l'unité de décision binaire reçoit des informations à priori produites par le module de traitement, envoie les informations à priori respectivement à l'unité de détermination d'arrêt d'itération et à l'unité contrôleur de mémoire de sortie, l'unité de détermination d'arrêt d'itération détermine si un résultat de la décision binaire répond à la condition d'arrêt, et produit pour le module de contrôle un signal de rétroaction indiquant que la condition est remplie ou que la condition n'est pas remplie; lorsque la condition d'arrêt est remplie, le module de commande envoie un signal de sortie à l'unité contrôleur de mémoire de sortie, et l'unité contrôleur de mémoire de sortie produit le résultat de décodage.

**7.** Appareil selon la revendication 6, dans lequel
la condition d'itération est considérée remplie si l'unité de détermination d'arrêt d'itération détermine que le résultat de décodage répond à n'importe laquelle des conditions suivantes : atteindre un certain nombre d'itérations; déterminer que le résultat d'un calcul de contrôle de redondance cyclique (CRC) sur les données des blocs décodés est correct.

**8.** Procédé pour décodage turbo en parallèle dans un système à technologie d'évolution à long terme (LTE), exécuté par l'appareil de décodage selon n'importe laquelle des revendications 1 à 7, comprenant les étapes suivantes :

stockage de bits souples de vérification d'entrée et une trame à décoder et lors du stockage de ladite trame à décoder, division de la trame à décoder en blocs, et stockage de chaque bloc respectivement en tant que bits système souples; réalisation d'un décodage de composant en même temps une fois sur plusieurs blocs de la trame à décoder et dans un processus de décodage de composant, division de chaque bloc en plusieurs fenêtres dynamiques en fonction d'un algorithme de fenêtre dynamique, et calcul des paramètres suivants en fonction des bits système souples, des bits souples de vérification et des informations a priori : valeur de mesure de branche $\gamma$, vecteur d'état avant $\alpha$, vecteur d'état inverse $\beta$, logarithme du rapport de vraisemblance (LLR), et informations a priori, et stockage des informations a priori à utiliser dans un prochain processus décodage unique de composant ; achèvement d'un processus de décodage après plusieurs implémentations de décodage de composant; réalisation d'une décision binaire sur le LLR, déterminant si un résultat de la décision binaire répond à une condition d'arrêt d'itération, et en cas affirmatif, production d'un résultat de décodage, en cas négatif, passage a un prochain processus de décodage par itération.

**9.** Procédé selon la revendication 8, dans lequel
un processus de décodage comprend l'exécution du décodage deux fois, et dans un processus de décodage, un premier décodage de composant est mis en oeuvre suivant les bits système souples, les deuxièmes informations à priori obtenues dans un dernier décodage de composant et un premier bit souple de vérification ; un deuxième décodage de décodage est mis en oeuvre suivant les bits système souples, une première information a priori obtenue dans un dernier décodage de composant et un deuxième bit souple de vérification ; les informations a priori dans le premier décodage de composant dans un premier processus de décodage sont 0.

**10.** Procédé selon la revendication 8, dans lequel
la condition d'arrêt d'itération est considérée remplie et l'itération sera arrêtée si le résultat de décodage répond à n'importe laquelle des conditions suivantes : atteindre un certain nombre d'itérations; déterminer que le résultat d'un calcul de contrôle de redondance cyclique (CRC) sur les données des blocs décodés est correct.

**11.** Procédé selon la revendication 8, où, un nombre N de blocs est déterminé selon une longueur K de la trame à décoder : lorsque $K \leq 512$, N = 1 ; lorsque $512 < K \leq 1024$, N = 2 ; lorsque $1024 < K \leq 2048$, N=4; lorsque $2048 < K \leq 6144$, N = 8.

**12.** Procédé selon la revendication 8, dans lequel
dans un processus d'exécution de calculs sur un certain bloc selon un algorithme de fenêtre dynamique, le bloc est divisé en plusieurs fenêtres dynamiques, dans lequel
au moment de calculer un vecteur d'état inverse $\beta$ d'une première fenêtre dynamique : une valeur de $\beta$ est calculée après L récurrences en assumant 0 comme valeur initiale, et ensuite cette valeur de $\beta$ est utilisée comme valeur initiale pour effectuer D calculs récursifs, pour obtenir ainsi D valeurs de $\beta$, qui sont utilisées comme valeurs de $\beta$ de la première fenêtre dynamique ;
au moment de calculer le vecteur d'état inverse $\beta$ d'une dernière fenêtre dynamique, si le bloc où se trouve la fenêtre dynamique est le dernier bloc, la valeur de $\beta$ de la dernière fenêtre dynamique est obtenue en effectuant D calculs récursifs avec 0 comme valeur initiale ; si le bloc où se trouve la fenêtre dynamique n'est pas le dernier bloc, une valeur de $\beta$ est calculée après L récurrences, d'abord avec 0 comme valeur initiale, et ensuite cette valeur de $\beta$ est utilisée comme valeur initiale pour effectuer D calculs récursifs, afin d'obtenir ainsi la valeur de $\beta$ de la dernière fenêtre dynamique ;
au moment de calculer le vecteur d'état avant $\alpha$ de la première fenêtre dynamique, si le bloc où se trouve la fenêtre dynamique est le premier bloc, la valeur de $\alpha$ de cette première fenêtre dynamique est obtenue en effectuant D calculs récursifs avec 0 comme valeur initiale ; si le bloc où se trouve la fenêtre dynamique n'est pas le premier bloc, une valeur de $\alpha$ est calculée après L récurrences, d'abord avec 0 comme valeur initiale, et ensuite la valeur de $\alpha$ est utilisée comme valeur initiale pour effectuer D calculs récursifs, afin d'obtenir ainsi la valeur de $\alpha$ de la première fenêtre dynamique ;

au moment de calculer un vecteur d'état avant α de la dernière fenêtre dynamique , une valeur de α est calculée après L récurrences en assumant 0 comme valeur initiale, et ensuite cette valeur de α est utilisée comme valeur initiale pour effectuer D calculs récursifs, pour obtenir ainsi D valeurs de α, qui sont utilisées comme valeurs de α de la première fenêtre dynamique ; dans lequel $1 \leq L \leq D$.

13. Procédé selon la revendication 8, dans lequel
le logarithme du rapport de vraisemblance (LLR) est calculé en même temps que le vecteur d'état avant α.

FIG. 1

FIG. 2

FIG. 3

FIG. 4

input data 1 →

| MAP calculating unit 1 |
|---|

| MAP calculating unit 2 |
|---|

input data 2 →

| MAP calculating unit 3 | → priori information
|---|

| MAP calculating unit 4 |
|---|

input data 3 →

| MAP calculating unit 5 | → LLR result
|---|

| MAP calculating unit 6 |
|---|

control signal →

| MAP calculating unit 7 |
|---|

| MAP calculating unit 8 |
|---|

FIG. 5

FIG. 6

FIG. 7

FIG. 8

β calculation

FIG. 9

α calculation

FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009043918 A